# EUROPEAN PATENT APPLICATION

(11) **EP 4 607 580 A1**
(43) Date of publication of application: **27.08.2025**
(21) Application number: 25159325.7
(22) Date of filing: 21.02.2025
(51) Int. Cl.: H01L 21/768, H01L 21/74, H01L 23/535, H10D 30/62

(54) **SEMICONDUCTOR DEVICE STRUCTURES AND METHODS FOR FORMING THE SAME**

(30) Priority: 21.02.2024 US 202463555917 P; 07.03.2024 US 202463562298 P
(71) Applicant: Invention and Collaboration Laboratory, Inc., Taipei City 114754 (TW)
(72) Inventor: LU, Chao-Chun, 300 Hsinchu (TW); TU, Wen-Hsien, 300 Hsinchu (TW)
(74) Representative: Krauns, Christian

(57) **Abstract**

Semiconductor device structures are provided. The semiconductor device structure includes a semiconductor substrate with an original semiconductor surface and an active region, a STI region surrounding the active region, a transistor formed based on the active region and including a gate structure, a first conductive region, a second conductive region and a channel region between the first and second conductive regions, an interconnection structure extending beyond the transistor, and a connecting plug electrically connecting the interconnection structure to the first conductive region of the transistor. The first conductive region includes an epitaxial semiconductor material. The interconnection structure is disposed under the original semiconductor surface and within the STI region.

## Description

### BACKGROUND

### Technical Field

The present disclosure relates to semiconductor structures, and more particularly to semiconductor device structures and methods for forming the same.

### Description of the Related Art

In the state-of-the-art integrated circuits, many transistors are connected by conductive interconnections (e.g. metal wires or polysilicon wires) to facilitate the signal transfer among the gate, the source and the drain regions (GSD) of these transistors. All these conductive interconnections are connected to GSD through a large number of contact holes and connection plugs, which poses significant challenges and difficulties to chip-design targets of reducing area, reducing power consumption, reducing noise and improving performances of integrated circuits especially when the dimensions of integrate circuits on dice must be shrunk significantly to meet requirements of scaling device dimensions in order to satisfy Moore's Law. To give an example about concerning on the area penalty: the size of the source or drain diffusion area must be designed to be larger than the size of the contact hole used to connect the conductive interconnections to source region or drain region in order to avoid unavoidable photolithographic misalignment, which results from the limitations of lithography equipment, causing the contact holes to be formed outside the underneath edges of the source region or drain region. This inevitably increases diffusion areas of transistors and thus die areas, which induces large capacitances to cause significant penalties to the AC performance of circuits, to consume higher power and to add larger noises. How to introduce a better self-aligned contact structure and technologies to connect a transistor to the first interconnection (Metal) layer with the smallest surface area to transmit and receive signals is a key challenge to further effectively scale down integrated circuits and improve performance of integrated circuits.

Moreover, the monolithic integration capability of a silicon chip has grown from GSI (Giga Scale Integration: Over billions of transistors on a die) toward TSI (Tera Scale Integration: Trillions of transistors on a die) soon and chip performance is being improved significantly. Accordingly, the power consumption of running such a huge number of transistors is increasing sharply, which elevates adversely the junction temperature of transistors and thus the entire chip temperature due to current limited heat-dissipation capability (e.g. thermal conductivity index of silicon-dioxide is very low and that of silicon is not very high). This material and device structural problem causes a negative cyclic effect, that is, the elevated higher die temperature slows down the speed of transistors, which inevitably forces the design to increase higher power to circuitry in order to accelerate the transistor performance; however, this mechanism causes badly raising the die temperature, and the heat-dissipation problem is getting worse eventually. Actually, this insufficient heat dissipation problem causing higher temperature to chip operation is regarded as the most serious problem that the entire chip industry needs to solve to avoid a major roadblock to a larger number of device integration on a die. The progress of reducing the temperature of a GSI chip is not improved well as it should be, however. Actually, as the transistor dimensions must become smaller as the technology node further shrinks (e.g. the minimum feature size shrinks from 7nm to 5nm, then to 3nm and so forth), the percentage of oxide coverage to the total transistor size is getting higher and the thermal dissipation capability across the device junctions is further being aggregated. Though a lot of heat dissipation methods are created, for example, covering the entire chip with higher heat-removal pad outside the chip or using a liquid cooling circulation outside the packaged chip, all of which are very expensive, inefficient, and cannot effectively reduce the junction temperatures of the transistors.

### SUMMARY

An embodiment of the present disclosure provides a semiconductor device structure. The semiconductor device structure includes a semiconductor substrate with an original semiconductor surface and an active region, a shallow trench isolation (STI) region surrounding the active region, a transistor formed based on the active region and including a gate structure, a first conductive region, a second conductive region and a channel region between the first conductive region and the second conductive region, an interconnection structure extending beyond the transistor, and a connecting plug electrically connecting the interconnection structure to the first conductive region of the transistor. The first conductive region includes an epitaxial semiconductor material. The interconnection structure is disposed under the original semiconductor surface and within the STI region. The connecting plug is within the active region and the epitaxial semiconductor material of the first conductive region is over a top surface of the connecting plug, or the connecting plug is within the STI region and the epitaxial semiconductor material of the first conductive region is connected to a first sidewall of the connecting plug.

According to an aspect of the present disclosure, the interconnection structure is isolated from the semiconductor substrate by an insulating region, the insulating region includes a first spacer on a first side of the interconnection structure and a second spacer on a second side of the interconnection structure, and the material of the first spacer is different from that of the second spacer.

According to an aspect of the present disclosure, a second sidewall of the connecting plug is aligned with and contacts to a sidewall of the interconnection.

According to an aspect of the present disclosure, the semiconductor device structure includes a trench within the active region. The connecting plug is positioned within the trench, and the connecting plug includes titanium nitride (TiN) and tungsten (W).

According to an aspect of the present disclosure, the semiconductor device structure includes a thin slot within the STI region, wherein the connecting plug is positioned within the thin slot, and the connecting plug includes a highly doped semiconductor material or TiN, wherein the epitaxial semiconductor material of the first conductive region is further over the top surface of the connecting plug, and the second sidewall of the connecting plug is opposite to the first sidewall of the connecting plug.

According to an aspect of the present disclosure, the transistor is a fin field-effect transistor (FinFET), a GAA transistor or a CFET, and the STI region has a top surface lower than the original semiconductor surface.

According to an aspect of the present disclosure, the first conductive region includes a selectively epitaxial grown material.

According to an aspect of the present disclosure, the connecting plug is within the active region, and the first conductive region only extends from a vertical sidewall of the active region right under a spacer structure covering the gate structure.

According to an aspect of the present disclosure, the connecting plug is within the STI region, and the first conductive region extends from a vertical sidewall of the active region right under a spacer structure covering the gate structure and from a horizontal surface of the active region close to the top surface of the STI region.

According to an aspect of the present disclosure, the semiconductor device structure includes a metal cap (M0) covering the first conductive region.

An embodiment of the present disclosure provides a semiconductor device structure. The semiconductor device structure includes a semiconductor substrate with an original semiconductor surface and an active region, a shallow trench isolation (STI) region surrounding the active region, a transistor formed based on the active region and including a gate structure, a first conductive region, a second conductive region and a channel region between the first conductive region and the second conductive region, an interconnection structure extending beyond the transistor, wherein the interconnection structure is disposed under the original semiconductor surface and within the STI region, a connecting plug electrically connecting the interconnection structure to the first conductive region of the transistor, and a metal cap (M0) covering an epitaxial semiconductor material of the first conductive region and the connecting plug.

According to an aspect of the present disclosure, the interconnection structure is isolated from the semiconductor substrate by an insulating region, the insulating region includes a first spacer on a first side of the interconnection structure and a second spacer on a second side of the interconnection structure, and the material of the first spacer is different from that of the second spacer.

According to an aspect of the present disclosure, a sidewall of the connecting plug is aligned with and contacts to a sidewall of the interconnection structure.

According to an aspect of the present disclosure, the semiconductor device structure includes a trench within the active region, wherein the connecting plug is positioned within the trench, and the connecting plug includes tungsten.

According to an aspect of the present disclosure, the transistor is a FinFET, the channel region includes a fin structure, and the STI region has a top surface lower than the original semiconductor surface.

According to an aspect of the present disclosure, the first conductive region includes an epitaxial semiconductor material.

According to an aspect of the present disclosure, the connecting plug is within the active region, and the first conductive region extends from a vertical sidewall of the fin structure right under a spacer structure covering the gate structure and from a horizontal surface of the active region close to the top surface of the STI region.

According to an aspect of the present disclosure, the transistor is a gate-all-around (GAA) transistor, the channel region includes a plurality of nanosheets, and the STI region has a top surface lower than the top of the plurality of nanosheets.

According to an aspect of the present disclosure, the first conductive region includes an epitaxial semiconductor material.

According to an aspect of the present disclosure, the connecting plug is within the active region, and the first conductive region extends from both vertical sidewalls of the plurality of nanosheets right under a spacer structure covering the gate structure and a horizontal surface of the active region close to the top surface of STI region.

An embodiment of the present disclosure provides a method for forming a semiconductor device structure. The method includes: preparing a semiconductor substrate with an original surface; based on the semiconductor substrate, forming an active region and forming a STI region surrounding the active region; forming asymmetric spacers within the STI region; forming an interconnection structure between the asymmetric spacers, wherein the interconnection structure is within the STI region and under the original surface of the semiconductor substrate; forming a connecting plug contacting the interconnection layer, wherein the connecting plug is within the active region or within the STI region; forming a first conductive region of a transistor based on the active region, wherein the first conductive region contacts the connecting plug.

According to an aspect of the present disclosure, the asymmetric spacers includes a first spacer and a second spacer, and the material of the first spacer is different from that of the second spacer.

According to an aspect of the present disclosure, the first spacer is made of silicon oxycarbonitride (SiOCN) or nitride, and the second spacer is made of silicon dioxide (SiO₂).

According to an aspect of the present disclosure, the step of forming the connection plug includes: etching a portion of the active region to form a trench within the active region to reveal the first spacer; based on the trench, removing the revealed first spacer to expose a sidewall of the interconnection structure; forming a conductive material in the trench to contact the sidewall of the interconnection structure.

According to an aspect of the present disclosure, the conductive material includes TiN and tungsten.

According to an aspect of the present disclosure, the conductive material includes tungsten.

According to an aspect of the present disclosure, the step of forming the connection plug includes: etching a portion of the active region to reveal a horizontal surface of the active region close to a top surface of the STI region such that a top surface of the first spacer is exposed; based on the exposed top surface of the first spacer, removing the first spacer to form a thin slot to reveal a sidewall of the interconnection layer; forming a conductive material in the thin slot to contact the sidewall of the first interconnection layer.

According to an aspect of the present disclosure, the conductive material includes a highly doped semiconductor material or TiN.

According to an aspect of the present disclosure, the step of forming the asymmetric spacers includes: forming the first spacer covering a sidewall of the active region and a temporary spacer covering a sidewall of another active region adjacent to the active region, wherein the first spacer and the temporary spacer are within the STI region, and the first spacer and the temporary spacer comprise the same material; forming a sacrificial layer within the STI region and covering the first spacer and the temporary spacer; removing the sacrificial layer and the temporary spacer to reveal the sidewall of the another active region; forming the second spacer covering the revealed sidewall of the another active region.

According to an aspect of the present disclosure, the step of forming the second spacer includes: oxidizing the revealed sidewall of the another active region.

According to an aspect of the present disclosure, the step of removing the sacrificial layer and the temporary spacer includes: forming a patterned photo-resistance layer to reveal portion of the sacrificial layer and the temporary spacer; removing the revealed sacrificial layer and the temporary spacer.

According to an aspect of the present disclosure, the method includes forming a metal cap covering the first conductive region and the connecting plug.

The above and other embodiments of the disclosure will become better understood with regard to the following detailed description of the non-limiting embodiment(s). The following description is made with reference to the accompanying drawings.

### BRIEF DESCRIPTION OF THE DRAWINGS

FIGS. 1A to 9 illustrate a method for forming underground interconnection structures within STI regions according to the first process embodiment of the present disclosure.
FIGS. 10A to 17C illustrate a method for forming underground interconnection structures within STI regions according to the second process embodiment of the present disclosure.
FIGS. 18 to 22C illustrate a method for electrically connecting an underground interconnection structure to a transistor according to the first connection embodiment of the present disclosure.
FIGS. 23 to 26 illustrate a method for electrically connecting an underground interconnection structure to a transistor according to the second connection embodiment of the present disclosure.
FIGS. 27 to 28 illustrate a method for electrically connecting an underground interconnection structure to a transistor according to the third connection embodiment of the present disclosure.
FIGS. 29 to 37A illustrate a method for electrically connecting an underground interconnection structure to a transistor according to the fourth connection embodiment of the present disclosure.
FIGS. 38 to 48A illustrate a method for electrically connecting an underground interconnection structure to a transistor according to the fifth connection embodiment of the present disclosure.
FIGS. 49 to 57A illustrate a method for electrically connecting an underground interconnection structure to a transistor according to the sixth connection embodiment of the present disclosure.

### DETAILED DESCRIPTION

Various embodiments will be described more fully hereinafter with reference to accompanying drawings, which are provided for illustrative and explaining purposes rather than a limiting purpose. For clarity, the components may not be drawn to scale. In addition, some components and/or reference numerals may be omitted from some drawings. It is contemplated that the elements and features of one embodiment can be beneficially incorporated in another embodiment without further recitation. In the following methods for forming semiconductor device structures, there may be one or more additional operations between the operations described, and the order of the operations may vary. The illustration uses the same/similar reference numerals to indicate the same/similar elements.

As used in the specification and the appended claims, the ordinals such as "first", "second" and the like to describe elements do not imply or represent a specific position in the structure, or the order of arrangement, or the order of manufacturing. The ordinals are only used to clearly distinguish multiple elements with the same name. As used in the specification and the appended claims, spatial relation terms such as "on", "above", "over", "upper," "top", "below", "beneath", "under", "lower", "bottom" and the like may be used to describe the relative spatial relations or positional relations between one element(s) and another element(s) as illustrated in the drawings, and these spatial relations or positional relations, unless specified otherwise, can be direct or indirect. The spatial relation terms are intended to encompass different orientations of structures in addition to the orientation depicted in the drawings. The structure can be inverted or rotated by various angles, and the spatial relation descriptions used herein can be interpreted accordingly.

Additionally, the terms "electrically connected" and "electrically coupled" used in the specification and claims can refer to current passing through elements, or an operational relation between elements. The operational relation may mean, for example, that one element is used to drive another element, but current may not flow directly between these two elements.

The present disclosure focuses on an underground interconnection (UGI) structure within a semiconductor substrate for signal delivery or heat dissipation application. The signal delivery includes power signal delivery and data signal delivery. The UGI structure may be made in a monolithic processes of making a transistor. For example, the transistor can be a fin field-effect transistor (FinFET) or a gate-all-around (GAA) transistor, or a Complementary FET (CFET), or a planar transistor. The underground interconnection structure may be an underground interconnection line (UGI line) or an underground interconnection pad (UGI pad).

### Forming an UGI structure under an original semiconductor surface

### <First process embodiment>

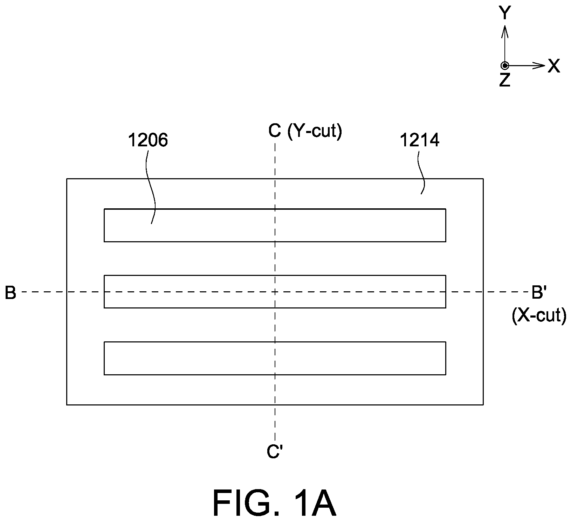

FIGS. 1A to 9 illustrate an exemplary method for manufacturing UGI structures according to the first embodiment of the present disclosure.

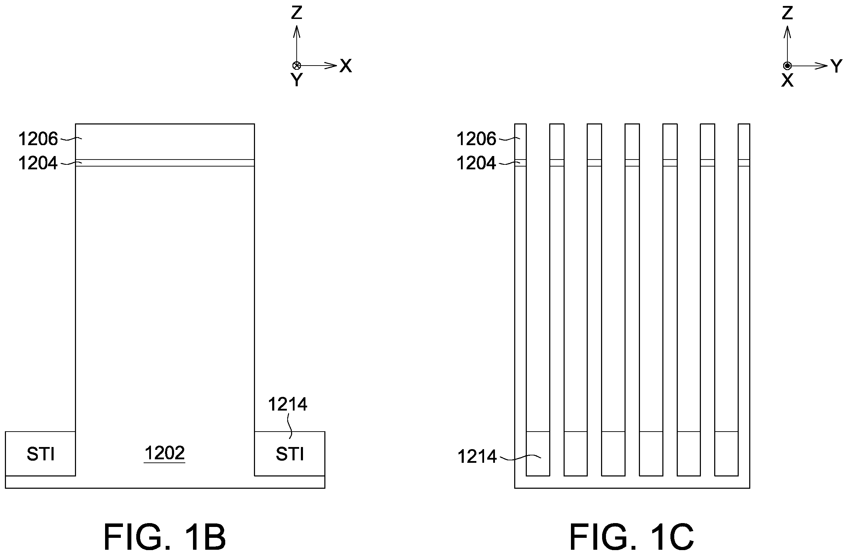

FIG. 1A illustrates a schematic top view of a structure at a stage of the manufacturing method, FIG. 1B illustrates a schematic cross-sectional view of the structure at the stage illustrated along the lines BB' shown in FIG. 1A, and FIG. 1C illustrates a schematic cross-sectional view of the structure at the stage illustrated along the lines CC' shown in FIG. 1A. Referring to FIGS. 1A to 1C, a pad-oxide layer 1204 and a pad-nitride layer 1206 are formed to define the active regions through deposition processes. A portion of the semiconductor substrate 1202 outside the active regions are removed. The semiconductor substrate 1202 may include or be made of a semiconductor material such as silicon. Then, an oxide layer is formed through a deposition process and an etching back process is performed to the oxide layer to form a shallow trench isolation (STI) region 1214. The STI region 1214 may surround the active regions.

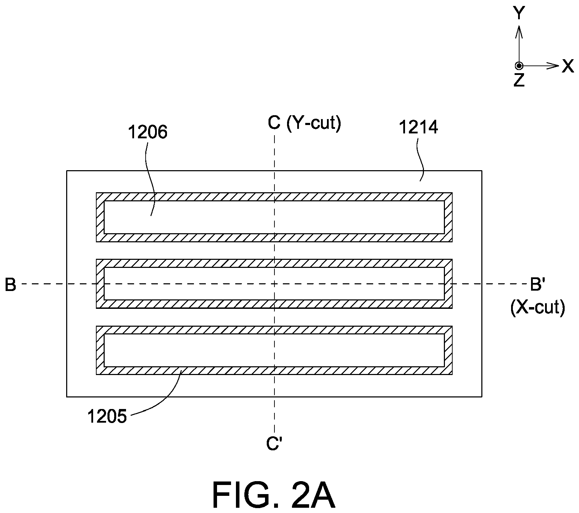

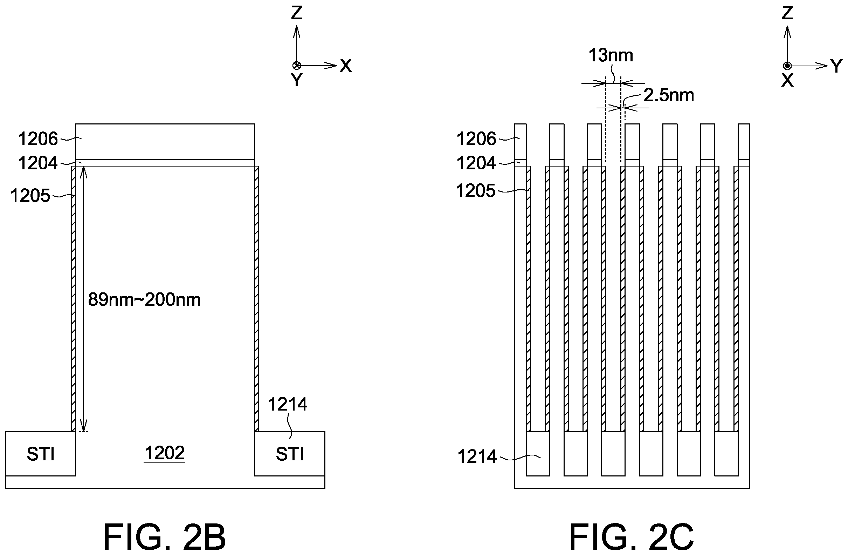

FIG. 2A illustrates a schematic top view of a structure at a stage of the manufacturing method, FIG. 2B illustrates a schematic cross-sectional view of the structure at the stage illustrated along the lines BB' shown in FIG. 2A, and FIG. 2C illustrates a schematic cross-sectional view of the structure at the stage illustrated along the lines CC' shown in FIG. 2A. Referring to FIGS. 2A to 2C, thermal oxide layers 1205 are grown along the revealed sidewalls of the active regions. The thermal oxide layers 1205 may be formed through oxidizing the revealed sidewalls of the active regions. The thermal oxide layer 1205 may have a length along the Z direction of about 89~200 nm. The thermal oxide layer 1205 may have a thickness along the Y direction of about 2.5 nm. Depending on the pitch of the active regions, the distance between the thermal oxide layers 1205 on different active regions along the Y direction may be about 13 nm. The upper surface of the thermal oxide layer 1205 can be lower than the upper surface of the pad-oxide layer 1204 and the lower surface of the pad-nitride layer 1206 in the Z direction. A portion of the STI region 1214 may be exposed, or the bottom of the STI region 1214 may be covered by the thermal oxide layers 1205 as well. In the present stage, a portion of the thermal oxide layers 1205 on the left side of an active region can be considered as a temporary spacer, and another portion of the thermal oxide layers 1205 on the right side (opposite to the left side) of this active region can be considered as a second spacer.

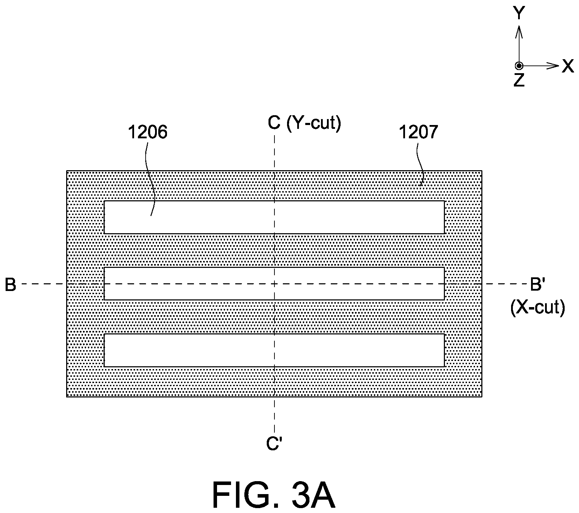

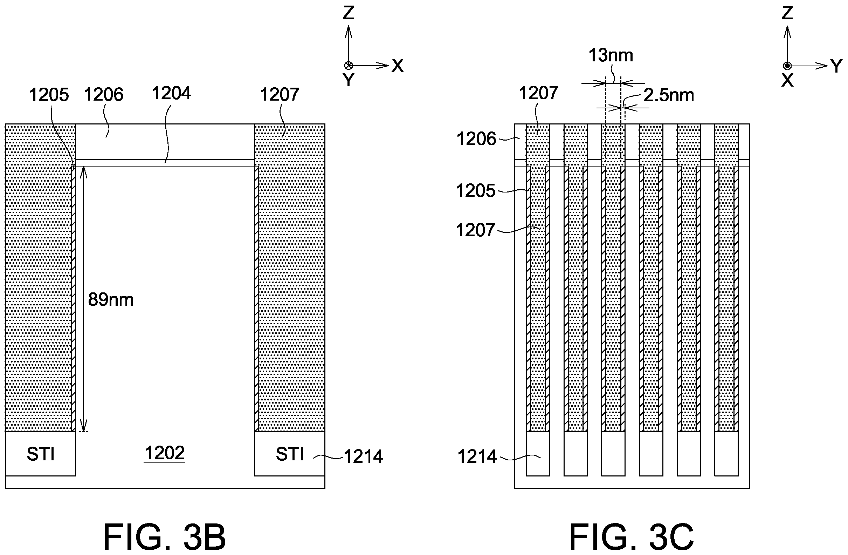

FIG. 3A illustrates a schematic top view of a structure at a stage of the manufacturing method, FIG. 3B illustrates a schematic cross-sectional view of the structure at the stage illustrated along the lines BB' shown in FIG. 3A, and FIG. 3C illustrates a schematic cross-sectional view of the structure at the stage illustrated along the lines CC' shown in FIG. 3A. Referring to FIGS. 3A to 3C, a SOD material 1207 fills the spaces between the active regions through a deposition process. A planarization process such as a chemical-mechanical planarization (CMP) process can be performed to remove a portion of the SOD material 1207 above the pad-nitride layer 1206 and make the upper surface of the SOD material 1207 and the upper surface of the pad-nitride layer 1206 coplanar. The SOD material 1207 can be considered as a sacrificial layer. The SOD material 1207 can cover the second spacer and the temporary spacer described in FIGS. 2A to 2C.

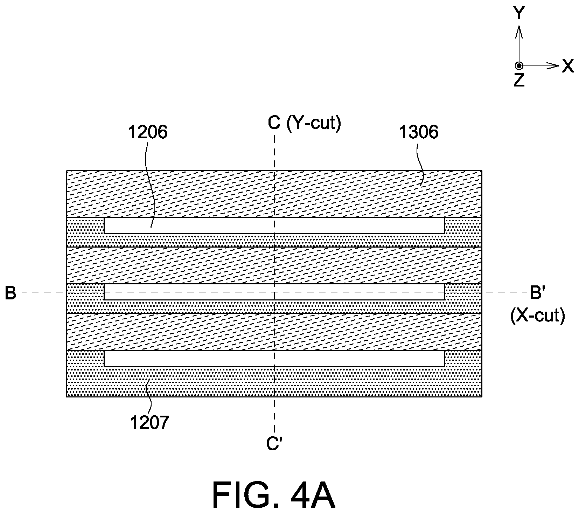

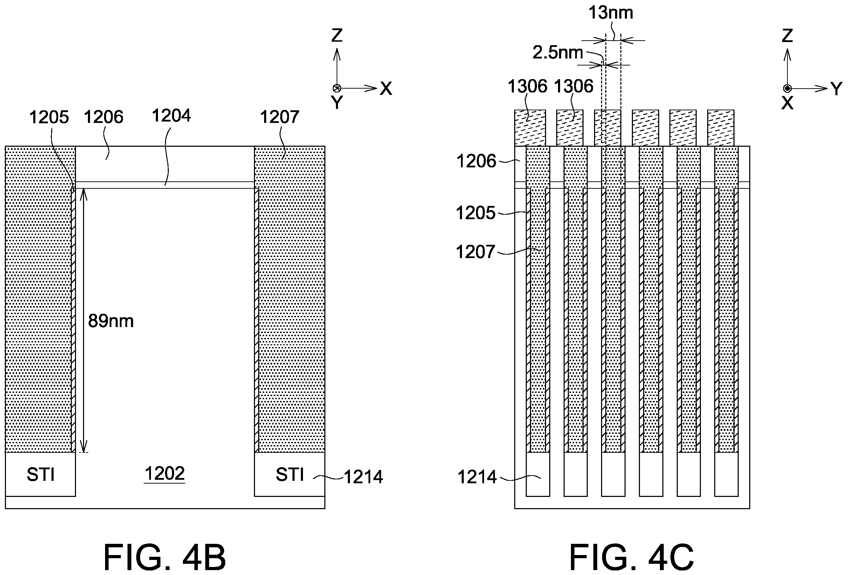

FIG. 4A illustrates a schematic top view of a structure at a stage of the manufacturing method, FIG. 4B illustrates a schematic cross-sectional view of the structure at the stage illustrated along the lines BB' shown in FIG. 4A, and FIG. 4C illustrates a schematic cross-sectional view of the structure at the stage illustrated along the lines CC' shown in FIG. 4A. Referring to FIGS. 4A to 4C, a photo-resistance layer 1306 is formed and patterned to cover a portion of the active region and expose a portion of the SOD material 1207. For example, half or more than half of the active region can be covered by the photo-resistance layer 1306.

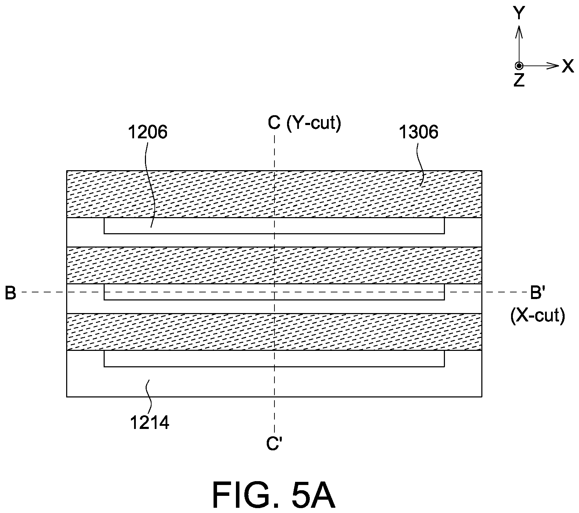

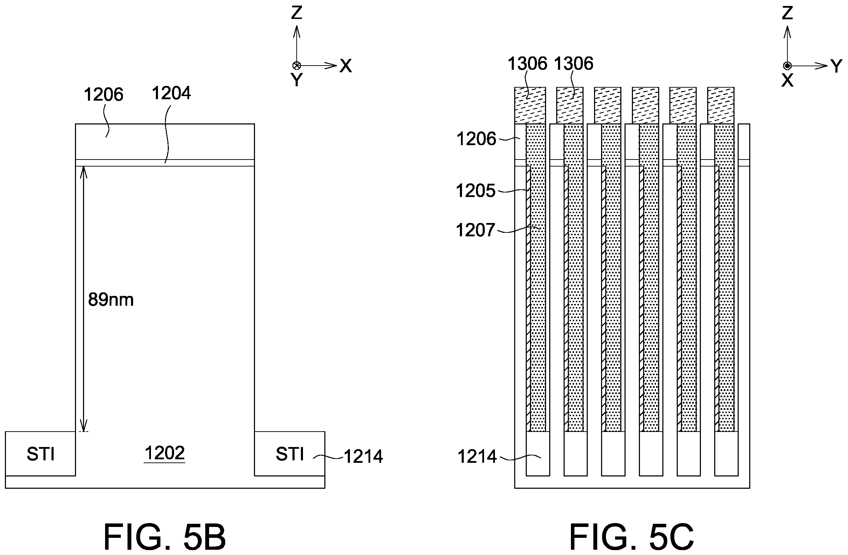

FIG. 5A illustrates a schematic top view of a structure at a stage of the manufacturing method, FIG. 5B illustrates a schematic cross-sectional view of the structure at the stage illustrated along the lines BB' shown in FIG. 5A, and FIG. 5C illustrates a schematic cross-sectional view of the structure at the stage illustrated along the lines CC' shown in FIG. 5A. Referring to FIGS. 5A to 5C, a portion of the SOD material 1207 that is not covered by the photo-resistance layer 1306 and the thermal oxide layer 1205 covered by this portion of the SOD material 1207 (i.e. the temporary spacer) are removed to form narrow slots between the retained SOD material 1207 and the active regions. The narrow slot may have a width along the Y direction of 2~6nm, such as 3nm. After the removing of a portion of the SOD material 1207 that is not covered by the photo-resistance layer 1306 and the removing of the thermal oxide layer 1205 thereunder, one sidewall of the active region is exposed in the narrow slot.

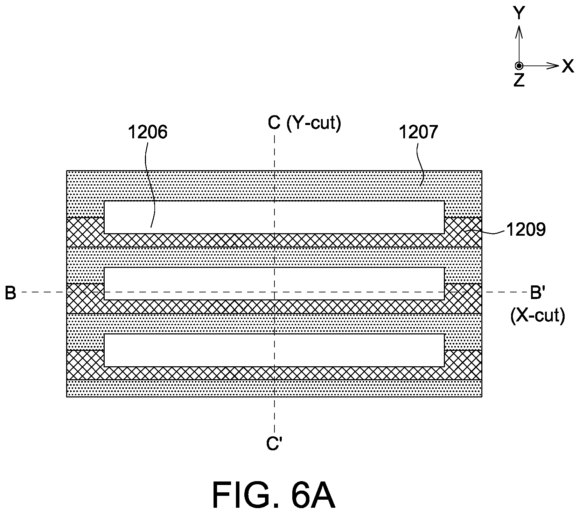

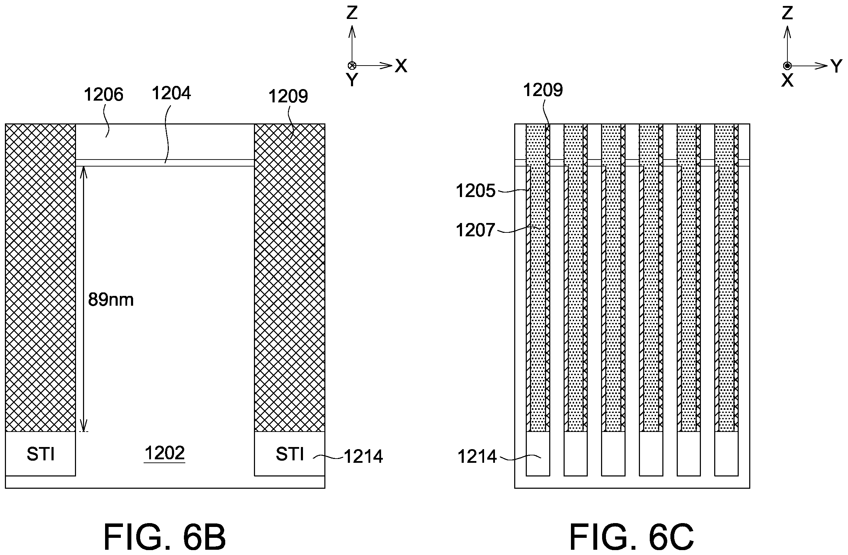

FIG. 6A illustrates a schematic top view of a structure at a stage of the manufacturing method, FIG. 6B illustrates a schematic cross-sectional view of the structure at the stage illustrated along the lines BB' shown in FIG. 6A, and FIG. 6C illustrates a schematic cross-sectional view of the structure at the stage illustrated along the lines CC' shown in FIG. 6A. Referring to FIGS. 6A to 6C, the photo-resistance layer 1306 is removed, and a material (such as SiOCN) 1209 different from the thermal oxide layer 1205 is formed within the narrow slots through a deposition process. A planarization process such as a CMP process can be performed to remove a portion of the SiOCN material 1209 above the pad-nitride layer 1206 and the SOD material 1207 and make the upper surface of the SiOCN material 1209, the upper surface of the SOD material 1207 and the upper surface of the pad-nitride layer 1206 coplanar. Therefore, asymmetric spacers which include different materials (such as the thermal oxide layer 1205 and the SiOCN material 1209) within the STI region 1214 are formed. In another view, such asymmetric spacers cover two sidewalls of the active regions, respectively. The SiOCN material 1209 can be considered as a first spacer. The asymmetric spacers can include the first spacer and the second spacer.

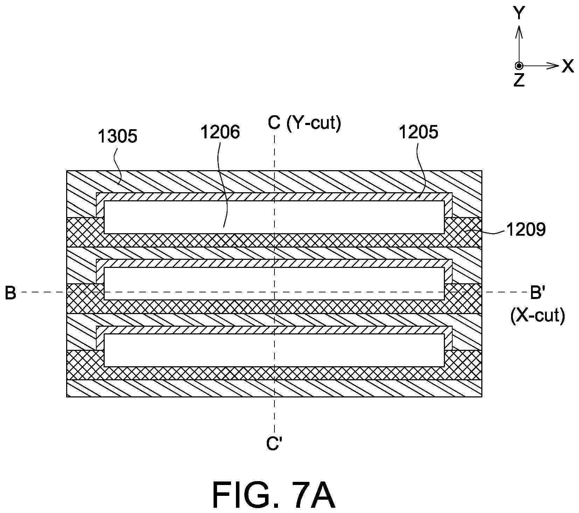

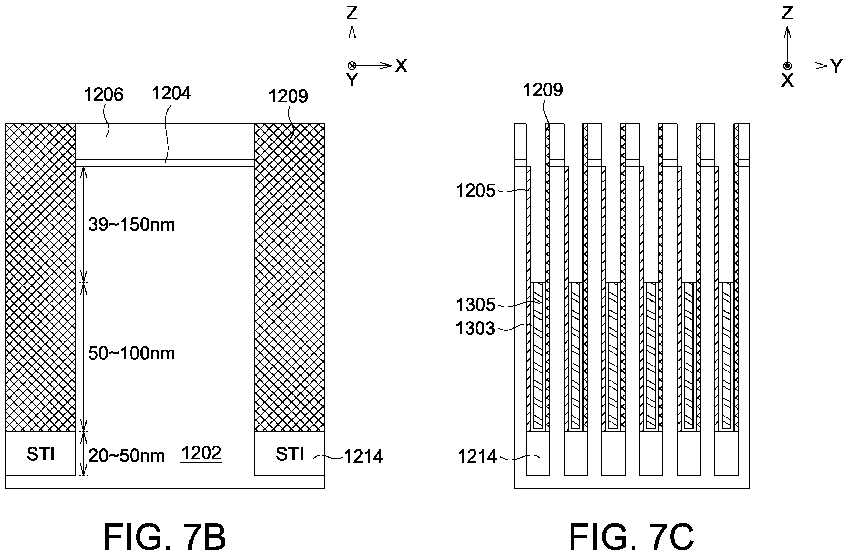

FIG. 7A illustrates a schematic top view of a structure at a stage of the manufacturing method, FIG. 7B illustrates a schematic cross-sectional view of the structure at the stage illustrated along the lines BB' shown in FIG. 7A, and FIG. 7C illustrates a schematic cross-sectional view of the structure at the stage illustrated along the lines CC' shown in FIG. 7A. Referring to FIGS. 7A to 7C, the SOD material 1207 is removed the form spaces between the thermal oxide layer 1205 and the SiOCN material 1209, then a conductive layer (such as a TiN layer 1303 and a tungsten layer 1305) are sequentially formed in the spaces through deposition processes, and then an etch back process is performed to remove a portion of the TiN layers 1303 and a portion of the tungsten layers 1305. After the etch back process, the retained tungsten layers 1305 can be defined as underground interconnection (UGI) structures, and the retained TiN layers 1303 can be defined as barrier layers. The TiN layer 1303 is between the tungsten layer 1305 and the thermal oxide layer 1205. The TiN layer 1303 is between the tungsten layer 1305 and the SiOCN material 1209 as well. The TiN layer 1303 is also between the tungsten layer 1305 and the STI region 1214. A distance between the upper surface of the thermal oxide layer 1205 and the upper surface of the tungsten layers 1305 along the Z direction could be 39~150 nm. A distance between the upper surface of the tungsten layers 1305 and the upper surface of the STI region 1214 along the Z direction could be 50~150 nm. A thickness of the STI region 1214 along the Z direction could be 20~50 nm.

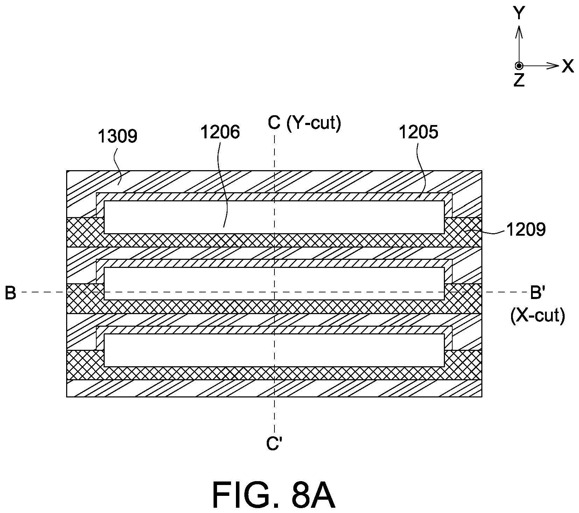

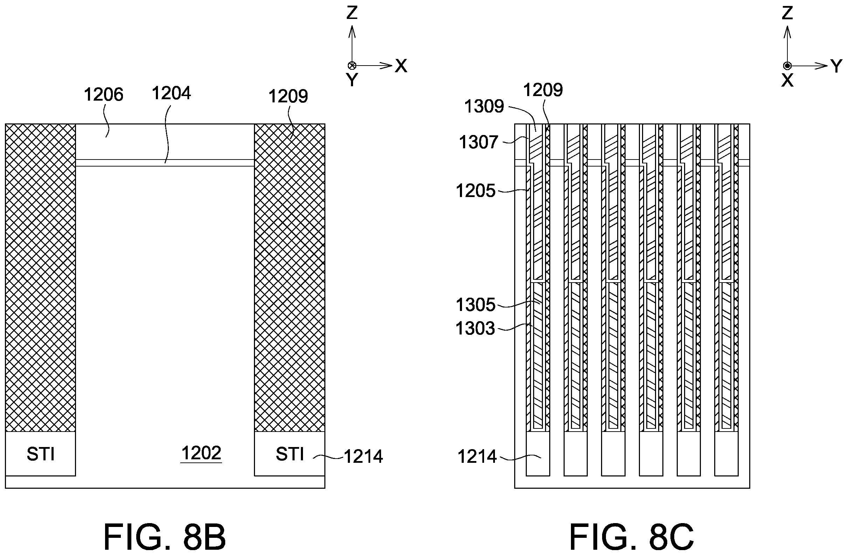

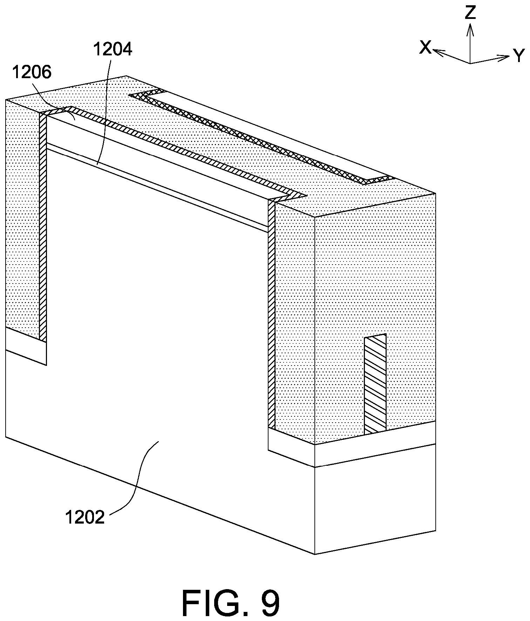

FIG. 8A illustrates a schematic top view of a structure at a stage of the manufacturing method, FIG. 8B illustrates a schematic cross-sectional view of the structure at the stage illustrated along the lines BB' shown in FIG. 8A, and FIG. 8C illustrates a schematic cross-sectional view of the structure at the stage illustrated along the lines CC' shown in FIG. 8A. Referring to FIGS. 8A to 8C, a SiN layer 1307 and a HDP (high density plasma) oxide layer 1309 are sequentially formed above the tungsten layers 1305 and the TiN layer 1303. Thus, the STI region between the active regions is completed. Therefore, underground interconnection structures within STI regions is provided, and a three-dimensional schematic view of the structure is shown in FIG. 9. Manufacturing steps for forming transistors in the active regions can be performed after the stage shown in FIG. 8A to 8C.

### <Second process embodiment>

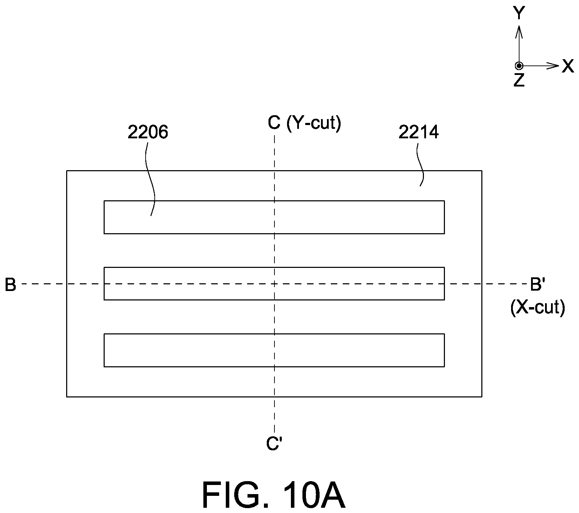

FIGS. 10A to 17C illustrate a method for manufacturing underground interconnection structures within STI regions according to the second embodiment of the present disclosure.

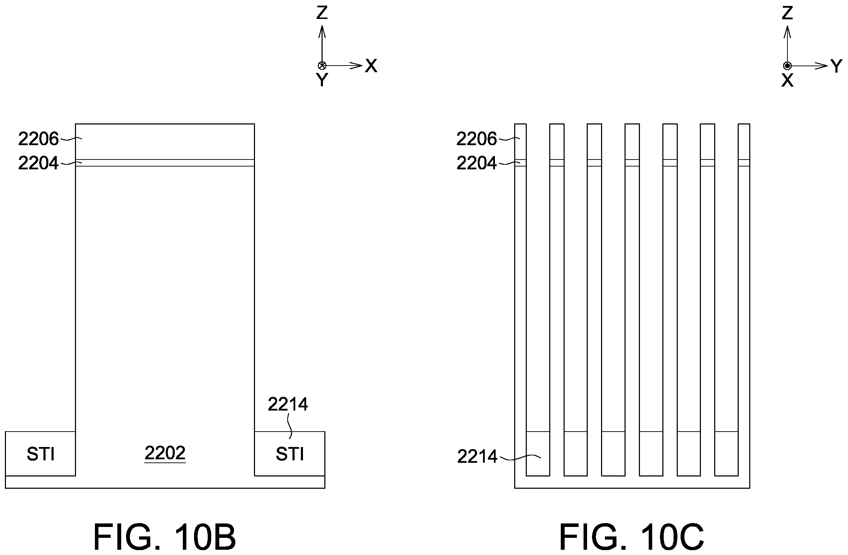

FIG. 10A illustrates a schematic top view of a structure at a stage of the manufacturing method, FIG. 10B illustrates a schematic cross-sectional view of the structure at the stage illustrated along the lines BB' shown in FIG. 10A, and FIG. 10C illustrates a schematic cross-sectional view of the structure at the stage illustrated along the lines CC' shown in FIG. 10A. Referring to FIGS. 10A to 10C, a pad-oxide layer 2204 and a pad-nitride layer 2206 are formed through deposition processes to define the active regions. A portion of the semiconductor substrate 2202 outside the active regions are removed. The semiconductor substrate 2202 may include or be made of a semiconductor material such as silicon. Then, an oxide layer is formed through a deposition process and an etching back process is performed to the oxide layer to form a shallow trench isolation (STI) region 2214. The STI region 2214 may surround the active regions. A width of the pad-nitride layer 2206 along the Y direction can be 12 nm. A distance between adjacent two active regions along the Y direction can be 18 nm. A distance between the lower surface of the pad-oxide layer 2204 and the upper surface of the STI region 2214 along the Z direction can range from 150 nm to 200 nm.

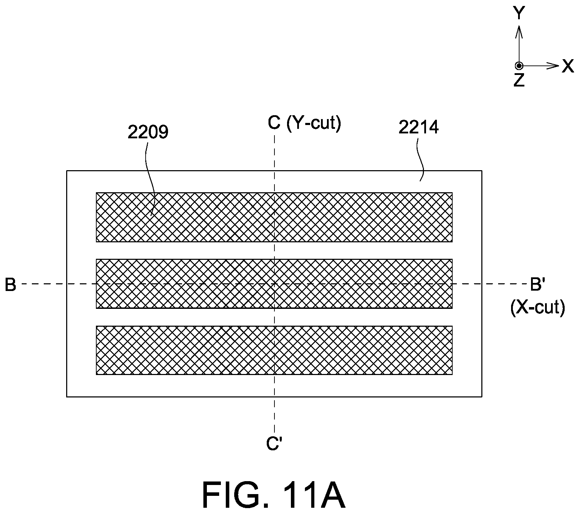

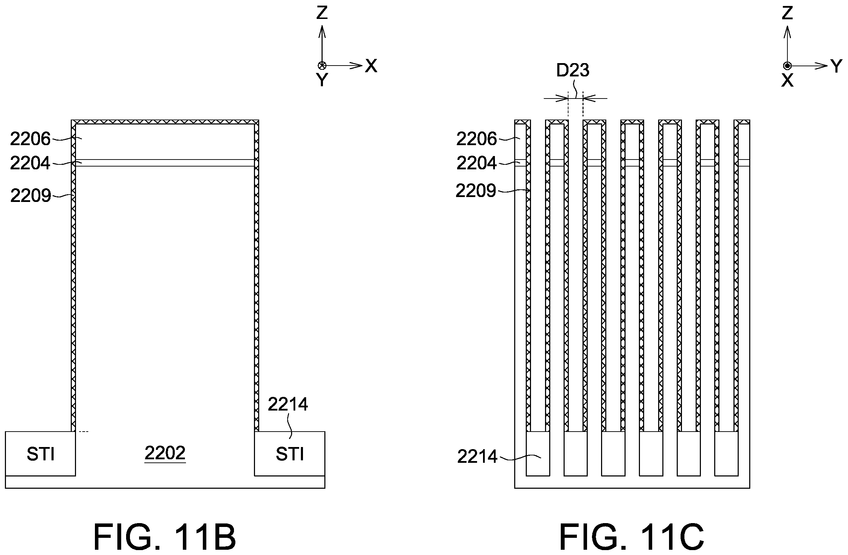

FIG. 11A illustrates a schematic top view of a structure at a stage of the manufacturing method, FIG. 11B illustrates a schematic cross-sectional view of the structure at the stage illustrated along the lines BB' shown in FIG. 11A, and FIG. 11C illustrates a schematic cross-sectional view of the structure at the stage illustrated along the lines CC' shown in FIG. 11A. Referring to FIGS. 11A to 11C, a SiOCN material 2209 is formed along the sidewall of the semiconductor substrate 2202, the sidewall of the pad-oxide layer 2204, the sidewall of the pad-nitride layer 2206 and the upper surface of the pad-nitride layer 2206 through a deposition process. A thickness of the SiOCN material 2209 along the Y direction can be 4 nm. A distance D23 between the sidewalls of the SiOCN material 2209 along the Y direction can be 10 nm. A portion of the STI region 2214 is then exposed. In the present stage, a portion of the SiOCN material 2209 on the right side of an active region can be considered as a temporary spacer, and another portion of the SiOCN material 2209 on the left side (opposite to the right side) of this active region can be considered as a first spacer.

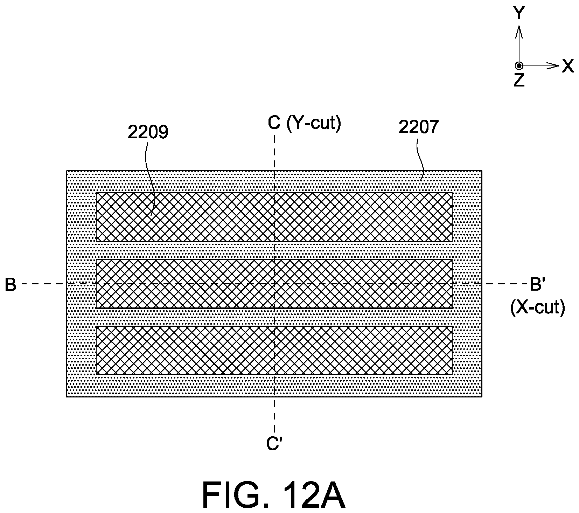

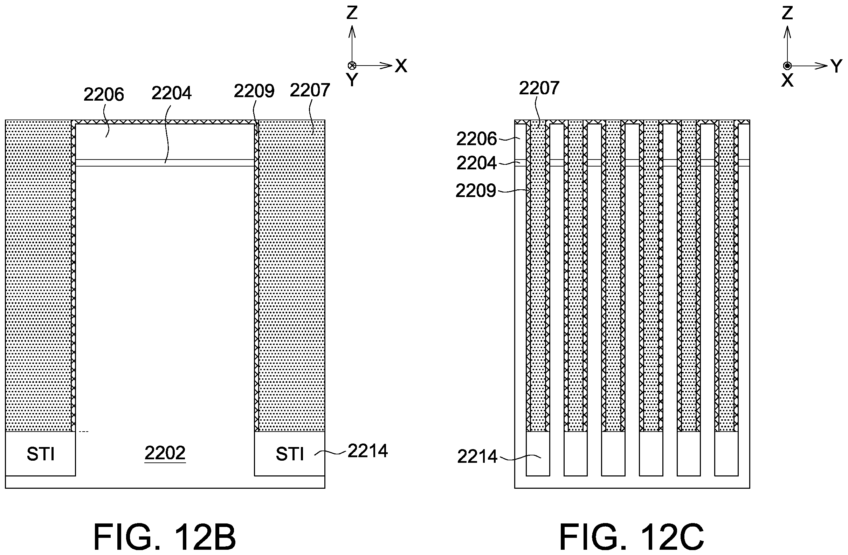

FIG. 12A illustrates a schematic top view of a structure at a stage of the manufacturing method, FIG. 12B illustrates a schematic cross-sectional view of the structure at the stage illustrated along the lines BB' shown in FIG. 12A, and FIG. 12C illustrates a schematic cross-sectional view of the structure at the stage illustrated along the lines CC' shown in FIG. 12A. Referring to FIGS. 12A to 12C, a SOD material 2207 fills the spaces between the active regions through a deposition process. A planarization process such as a CMP process can be performed to remove a portion of the SOD material 2207 above the pad-nitride layer 2206 and make the upper surface of the SOD material 2207 and the upper surface of the pad-nitride layer 2206 coplanar. The SOD material 2207 can be considered as a sacrificial layer. The SOD material 2207 can cover the first spacer and the temporary spacer described in FIGS. 11A to 11C.

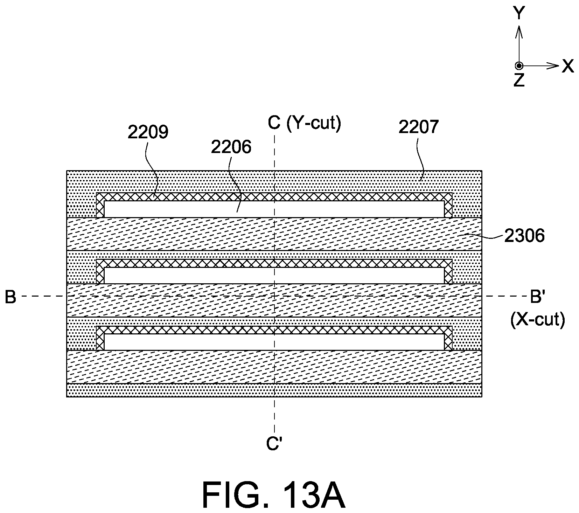

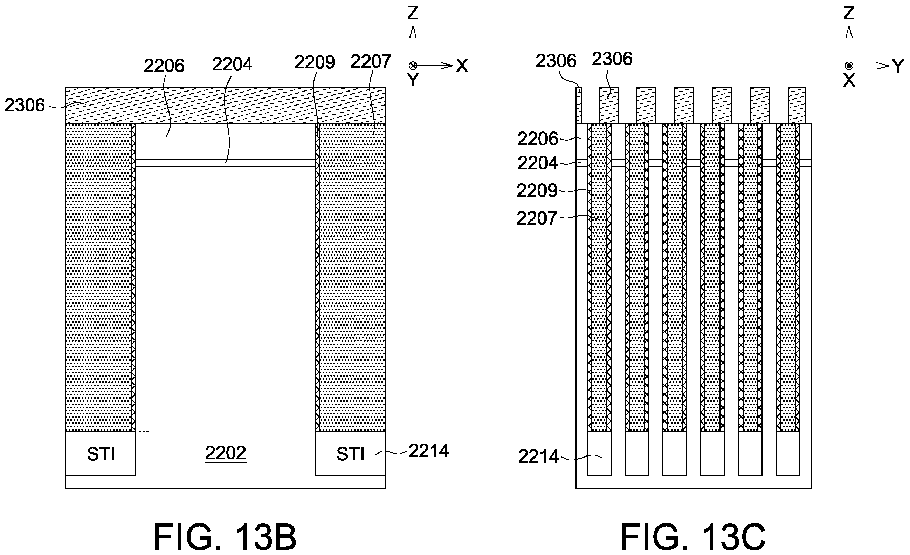

FIG. 13A illustrates a schematic top view of a structure at a stage of the manufacturing method, FIG. 13B illustrates a schematic cross-sectional view of the structure at the stage illustrated along the lines BB' shown in FIG. 13A, and FIG. 13C illustrates a schematic cross-sectional view of the structure at the stage illustrated along the lines CC' shown in FIG. 13A. Referring to FIGS. 13A to 13C, a photo-resistance layer 2306 is formed and patterned to cover a portion of the active region and expose a portion of the SOD material 2207 and a portion of the SiOCN material 2209 (i.e. the temporary spacer). For example, half or more than half of the active region can be covered by the photo-resistance layer 2306.

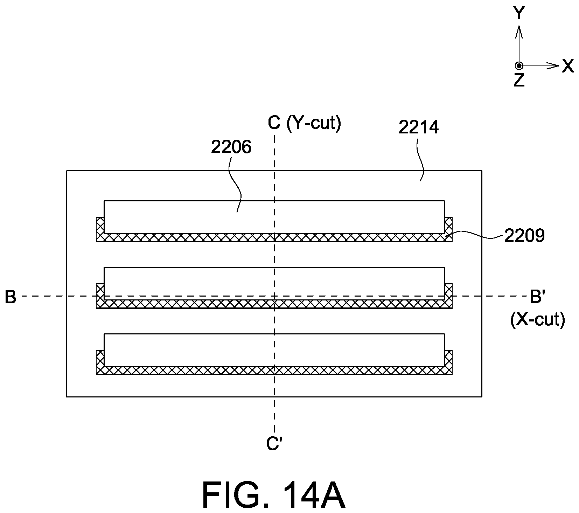

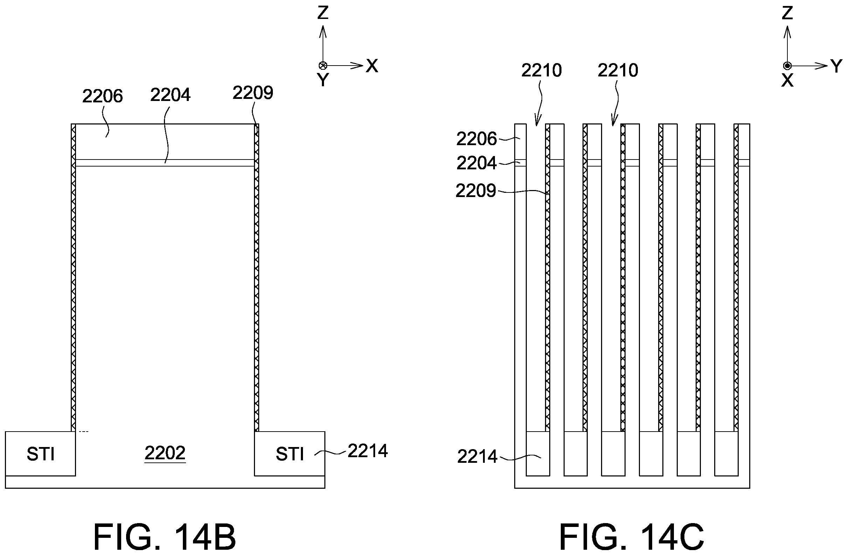

FIG. 14A illustrates a schematic top view of a structure at a stage of the manufacturing method, FIG. 14B illustrates a schematic cross-sectional view of the structure at the stage illustrated along the lines BB' shown in FIG. 14A, and FIG. 14C illustrates a schematic cross-sectional view of the structure at the stage illustrated along the lines CC' shown in FIG. 14A. Referring to FIGS. 14A to 14C, the portion of the SiOCN material 2209 that is not covered by the photo-resistance layer 2306 (i.e. the temporary spacer) and the SOD material 2207 are removed, and the photo-resistance layer 2306 is removed. Slots 2210 are formed between the retained SiOCN material 2209 and the active regions. After the removing, one sidewall of each active region is exposed in the slots 2210.

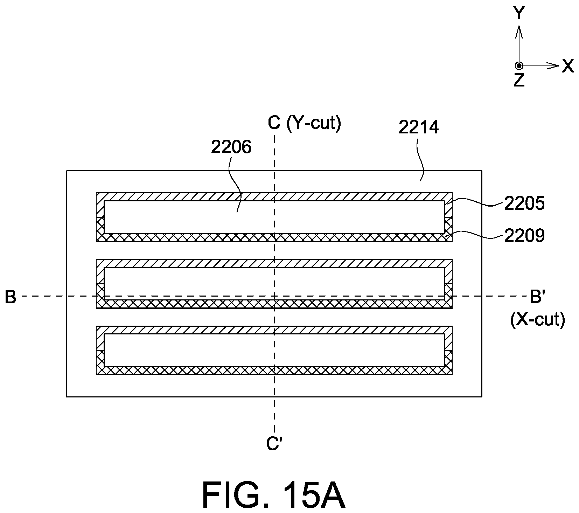

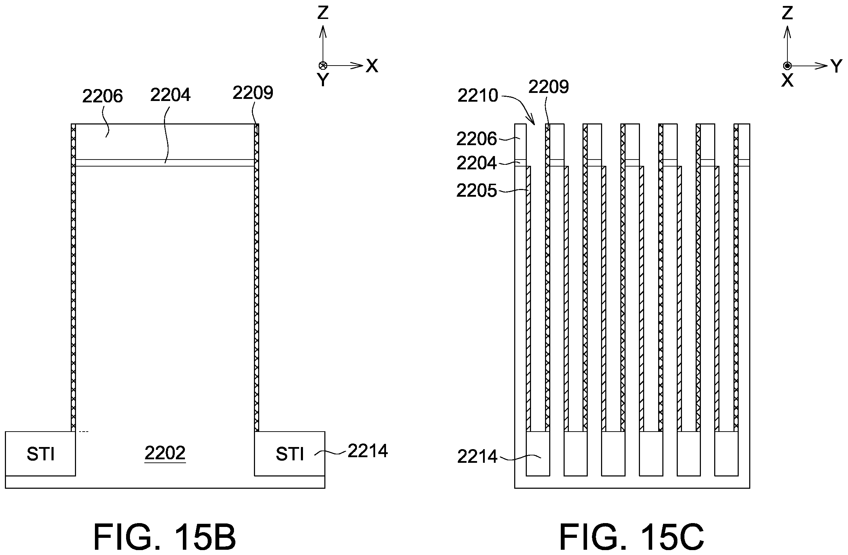

FIG. 15A illustrates a schematic top view of a structure at a stage of the manufacturing method, FIG. 15B illustrates a schematic cross-sectional view of the structure at the stage illustrated along the lines BB' shown in FIG. 15A, and FIG. 15C illustrates a schematic cross-sectional view of the structure at the stage illustrated along the lines CC' shown in FIG. 15A. Referring to FIGS. 15A to 15C, thermal oxide layers 2205 are grown along the exposed sidewalls of the active regions and within the slots 2210. The thermal oxide layers 2205 may be formed through oxidizing the revealed sidewalls of the active regions. The upper surface of the thermal oxide layer 2205 can be lower than the upper surface of the pad-oxide layer 2204 and the lower surface of the pad-nitride layer 2206 in the Z direction. Therefore, asymmetric spacers which include different materials (such as the thermal oxide layer 2205 and the SiOCN material 2209) within the STI region 2214 are formed. In another view, such asymmetric spacers cover two sidewalls of each active region (or cover two sidewalls of each STI region). The thermal oxide layers 2205 can be considered as a second spacer. The asymmetric spacers can include the first spacer and the second spacer.

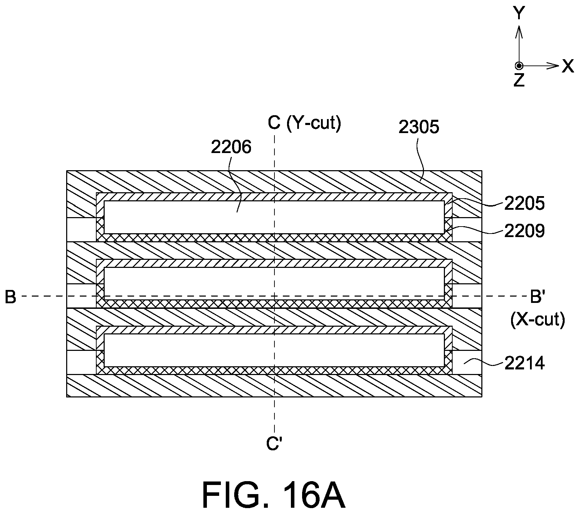

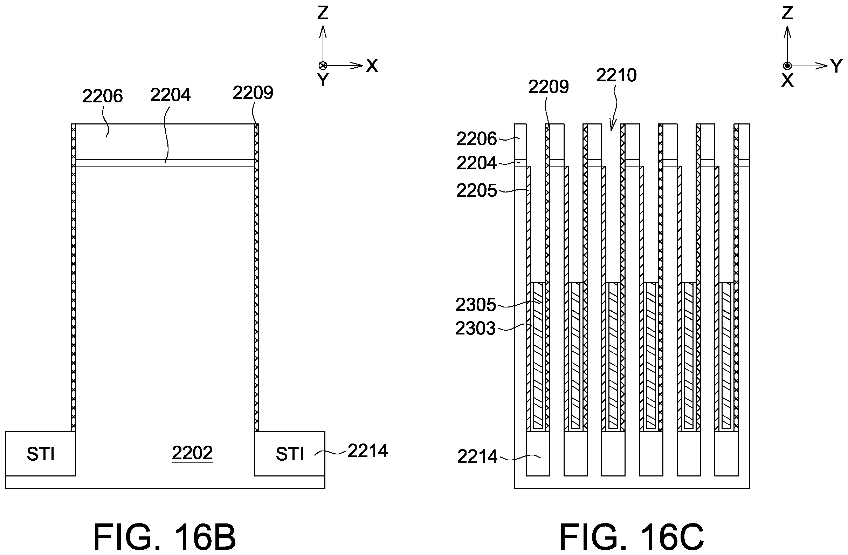

FIG. 16A illustrates a schematic top view of a structure at a stage of the manufacturing method, FIG. 16B illustrates a schematic cross-sectional view of the structure at the stage illustrated along the lines BB' shown in FIG. 16A, and FIG. 16C illustrates a schematic cross-sectional view of the structure at the stage illustrated along the lines CC' shown in FIG. 16A. Referring to FIGS. 16A to 16C, a TiN layer 2303 and a tungsten layer 2305 are sequentially formed within the slots 2210 through deposition processes, and then an etch back process is performed to remove a portion of the TiN layers 2303 and a portion of the tungsten layers 2305. After the etch back process, a photolithograph process is performed to divide the TiN layers 2303 and the tungsten layers 2305 into several retained TiN layers 2303 and retained tungsten layers 2305. The retained tungsten layers 2305 can be defined as underground interconnection (UGI) structures, and the retained TiN layers 2303 can be defined as barrier layers.

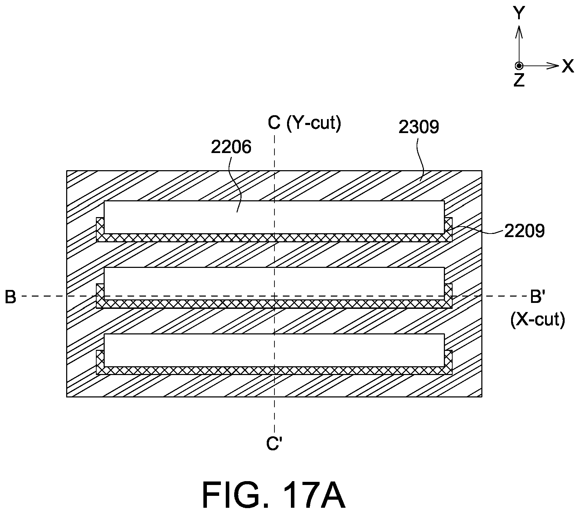

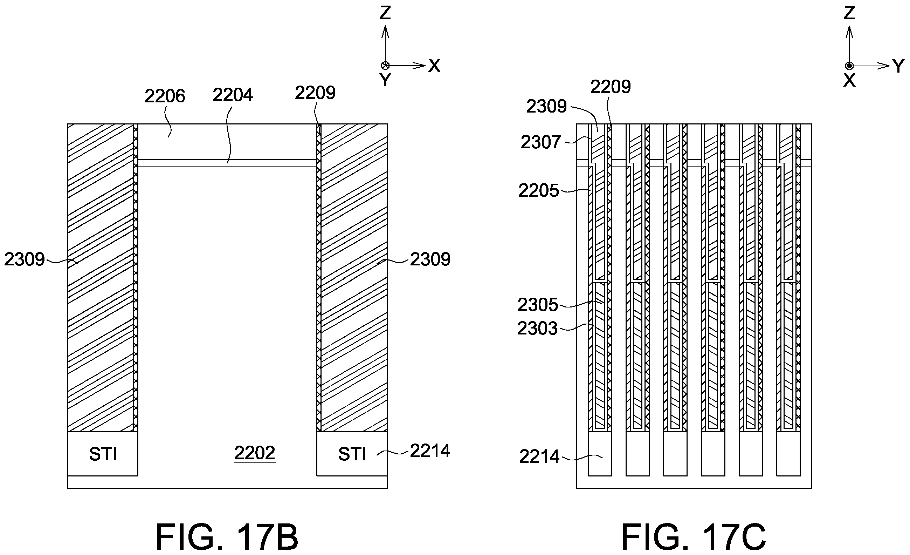

FIG. 17A illustrates a schematic top view of a structure at a stage of the manufacturing method, FIG. 17B illustrates a schematic cross-sectional view of the structure at the stage illustrated along the lines BB' shown in FIG. 17A, and FIG. 17C illustrates a schematic cross-sectional view of the structure at the stage illustrated along the lines CC' shown in FIG. 17A. Referring to FIGS. 17A to 17C, a SiN layer 2307 and a HDP (high density plasma) oxide layer 2309 are sequentially formed above the tungsten layers 2305 and the TiN layer 2303. Therefore, a structure including underground interconnection structures within STI regions is provided. Manufacturing steps for forming transistors in the active regions can be performed after the stage shown in FIG. 17A to 17C.

Through the methods shown in FIGS. 1A to 17C, underground interconnection structures (e.g. the tungsten layers 1305 shown in FIG. 8C and the tungsten layers 2305 shown in FIG. 17C) under the original semiconductor surface and within the STI regions are provided. The UGI structures can extend along the STI regions. The UGI structures are isolated from the semiconductor substrate, and depending on the requirement, some UGI structures can be electrically connected to the transistors. In an embodiment, the UGI structure can be electrically connected to a source terminal or a drain terminal of a transistor through a connecting plug within the active region accommodating the transistor by a self-aligned or self-constructed method. Forming asymmetric spacers (e.g. the thermal oxide layer 1205 and the SiOCN material 1209 shown in FIG. 8C, and the thermal oxide layer 2205 and the SiOCN material 2209 shown in FIG. 17C) along the sidewalls of the active region and forming the UGI structure between the asymmetric spacers and below the original semiconductor surface are important in the present disclosure. The UGI structures within the semiconductor substrate can form a UGI mesh extending far away from those active regions to other spare or big STI region, and the UGI mesh can be understood as a middle side signal delivery network ("Mid-side Signal Network") and/or heat dissipation network. The use of UGI mesh within the chip or semiconductor substrate can provide bigger misalignment tolerance due to the big STI regions with a lot of space for signal path, shorten the path to connect backside TSVs to UGI mesh to improve IR drop of the signal delivery, enhance the heat dissipation, and improve the previously mentioned drawbacks of IC mainly formed by transistors.

### Electrical connection between the UGI structure and a fin field-effect transistor

The following content uses a FinFET as an example to illustrate how to electrically connect the UGI structure to the source terminal or the drain terminal of the transistor. The source terminal or the drain terminal of the FinFET can be formed by a selective epitaxy growth process. The techniques described here can also be applied to an electrical connection between the UGI structure and a source/drain terminal of a GAA transistor, a CFET, or a planar transistor (the source/drain terminal of the planar transistor can be formed by an ion implantation process).

### <First connection embodiment>

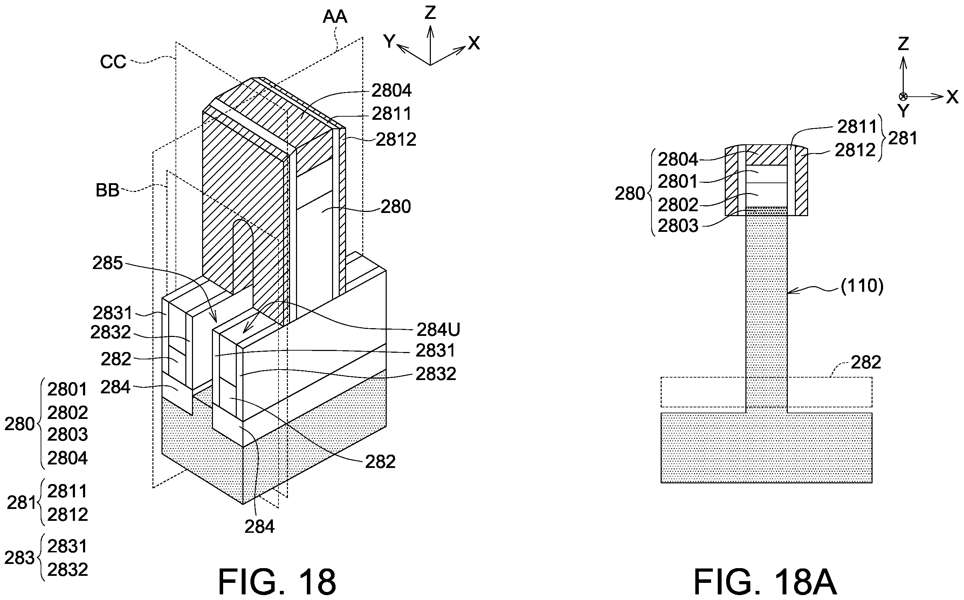

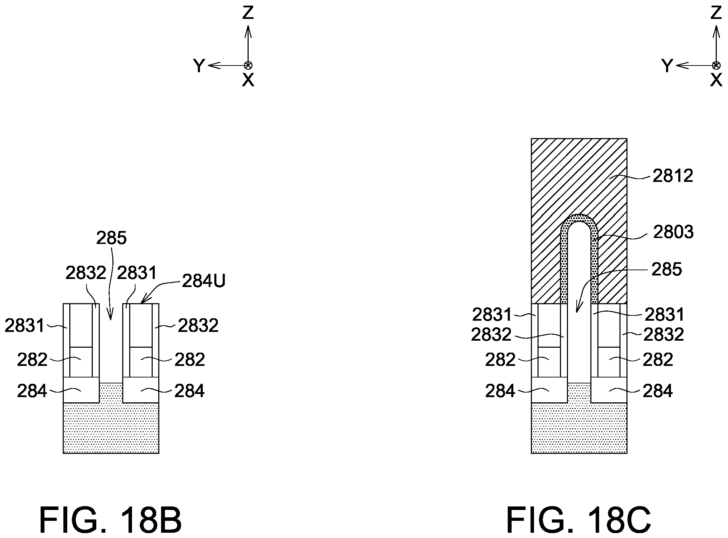

FIGS. 18 to 22C illustrate a method for electrically connecting an underground interconnection structure to a transistor according to this embodiment of the present disclosure. In an embodiment, the manufacturing steps illustrated with reference to FIGS. 18 to 22C can be performed after the manufacturing steps illustrated with reference to FIGS. 1A to 9 or the manufacturing steps illustrated with reference to FIGS. 10A to 17C.

FIG. 18 illustrates a three-dimensional schematic view of a structure at a stage of the manufacturing method, FIG. 18A shows a schematic cross-sectional view of the structure illustrated along the lines AA shown in FIG. 18, FIG. 18B shows a schematic cross-sectional view of the structure illustrated along the lines BB shown in FIG. 18, and FIG. 18C shows a schematic cross-sectional view of the structure illustrated along the lines CC shown in FIG. 18. Referring to FIGS. 18 to 18C, after forming the structure including the UGI structure 282 protected by asymmetric spacers 283 in the STI region 284, a dummy gate structure 280 (or real gate structure if necessary) and a spacer structure 281 covering the dummy gate structure 280 are formed based on standard foundry processes, and a portion of active region (or fin structure) outside the spacer structure 281 and above the top surface 284U of the STI region 284 will be revealed. The dummy gate structure 280 may include a cap nitride layer 2804, a cap oxide layer 2801, a semiconductor layer 2802, and a high-k dielectric layer 2803 stacked along the Z direction. The semiconductor layer 2802 can be between the cap oxide layer 2801 and the high-k dielectric layer 2803. The cap oxide layer 2801 may include oxide. The semiconductor layer 2802 may include a semiconductor material such as polycrystalline silicon. The high-k dielectric layer 2803 may include a dielectric material with a high dielectric constant. The spacer structure 281 may be a composite of a first spacer material 2811 and a second spacer material 2812 different from the first spacer material 2811. In an embodiment, the first spacer material 2811 can be oxide, and the second spacer material 2812 can be nitride. The spacer structure 281 may cover the opposite sidewalls of the dummy gate structure 280. The UGI structure 282 can be any conductive material (such as the tungsten layer 1305 shown in FIG. 8C or the tungsten layer 2305 shown in FIG. 17C). The STI region 284 can be the STI region 1214 shown in FIG. 8C or the STI region 2214 shown in FIG. 17C. The asymmetric spacers 283 includes a first spacer 2831 covering a first side of the UGI structure 282 and a second spacer 2832 covering a second side of the UGI structure 282. The first side of the UGI structure 282 is opposite to the second side of the UGI structure 282. The material of the first spacer 2831 is different from that of the second spacer 2832. The first spacers 2831 and the second spacers 2832 can be arranged alternately along the Y direction. The first spacer 2831 can be the SiOCN material 1209 shown in FIG. 8C or the SiOCN material 2209 shown in FIG. 17C. The second spacer 2832 can be the thermal oxide layer 1205 shown in FIG. 8C or the thermal oxide layer 2205 shown in FIG. 17C.

Then, the revealed portion of the active region and other fin structure made of silicon under the revealed portion of the active region (below the top surface 284U of STI region 284) are removed by an etching process, such that a trench 285 is formed to reveal the above-mentioned asymmetric spacers 283, and a vertical sidewall of the active region with a crystalline orientation (110) right under the spacer structure 281 covering the dummy gate structure 280 is revealed as well. The trench 285 is within the active region.

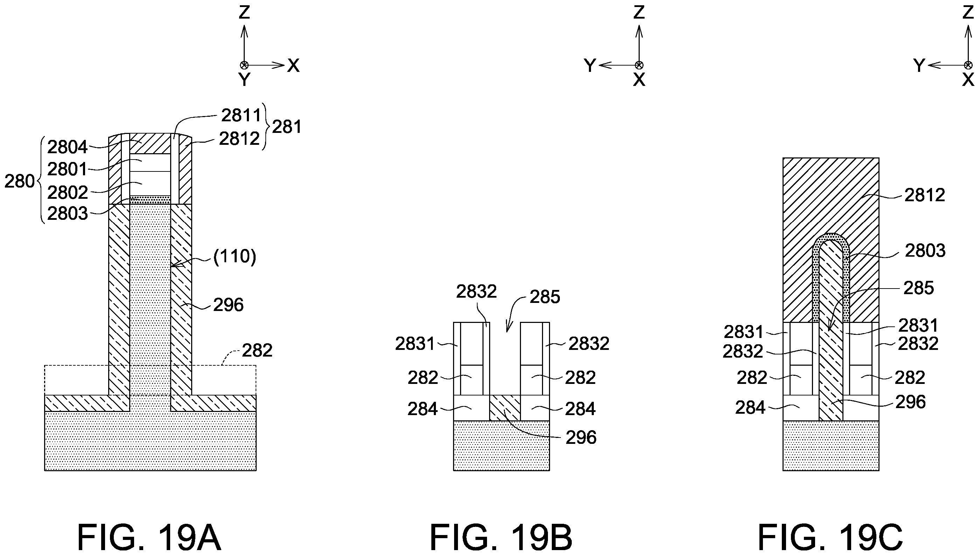

FIG. 19A to 19C shows schematic cross-sectional views of a structure at a stage of the manufacturing method, obtained by cutting the structure at different angles. The cross-sectional views of FIG. 18A and FIG. 19A are obtained at substantially the same angle and substantially the same position. The cross-sectional views of FIG. 18B and FIG. 19B are obtained at substantially the same angle and substantially the same position. The cross-sectional views of FIG. 18C and FIG. 19C are obtained at substantially the same angle and substantially the same position. Referring to FIGS. 19A to 19C, a thermal oxide layer 296 is formed at the bottom of the trench 285 through a thermal oxidation process, and the aforesaid vertical sidewall of the active region with the crystalline orientation (110) is oxidized as well. One of the asymmetric spacers 283, the first spacer 2831, exposed by the trench 285 is then removed by an etching process to reveal the sidewall of the UGI structure 282, and the second spacer 2832 is retained (as shown in FIG. 19B). In an embodiment, if a nitride spacer (e.g. the TiN layer 1303 shown in FIG. 8C or 2303 shown in FIG. 17C) is used, the nitride spacer will be removed together with the first spacer 2831. The thermal oxide layer 296 may include silicon dioxide (SiO₂).

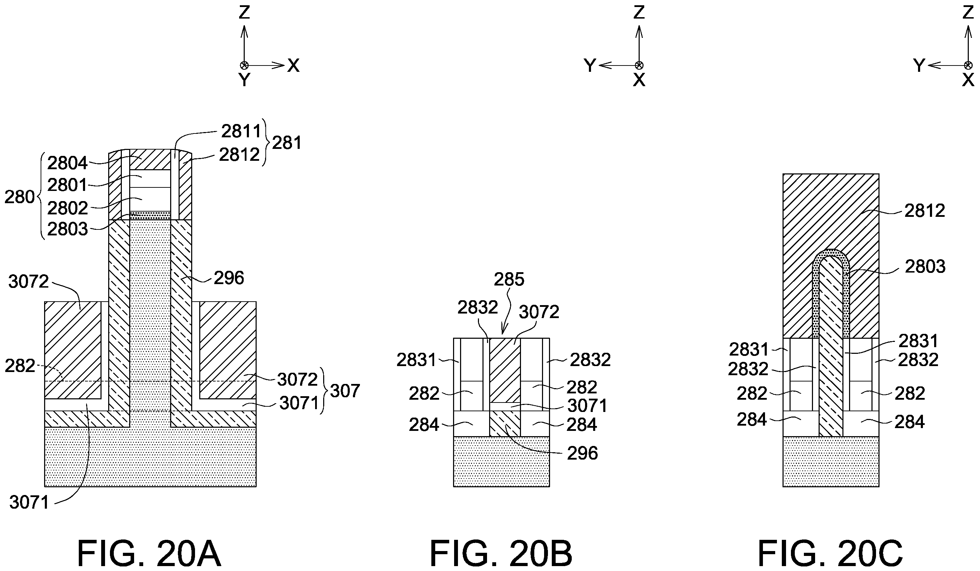

FIG. 20A to 20C shows schematic cross-sectional views of a structure at a stage of the manufacturing method, obtained by cutting the structure at different angles. The cross-sectional views of FIG. 18A and FIG. 20A are obtained at substantially the same angle and substantially the same position. The cross-sectional views of FIG. 18B and FIG. 20B are obtained at substantially the same angle and substantially the same position. The cross-sectional views of FIG. 18C and FIG. 20C are obtained at substantially the same angle and substantially the same position. Referring to FIGS. 20A to 20C, a TiN film 3071 and a conductive film 3072 are formed in the trench 285 through an atomic layer deposition process. The TiN film 3071 can be formed on an upper surface and a sidewall of the thermal oxide layer 296. The conductive film 3072 can be formed on an upper surface and a sidewall of the TiN film 3071. The TiN film 3071 can be between the conductive film 3072 and the thermal oxide layer 296. The TiN film 3071 and the conductive film 3072 can form a connecting plug 307 for electrically connecting the revealed sidewall of the UGI structure 282. The connecting plug 307 may contact the revealed sidewall of the UGI structure 282, as shown in FIG. 20B. The conductive film 3072 may include or be made of a conductive material such as tungsten (W). The connecting plug 307 is formed within the active region. A portion of the thermal oxide layer 296 is covered by the connecting plug 307, while another portion of the thermal oxide layer 296 is revealed, as shown in FIG. 20C.

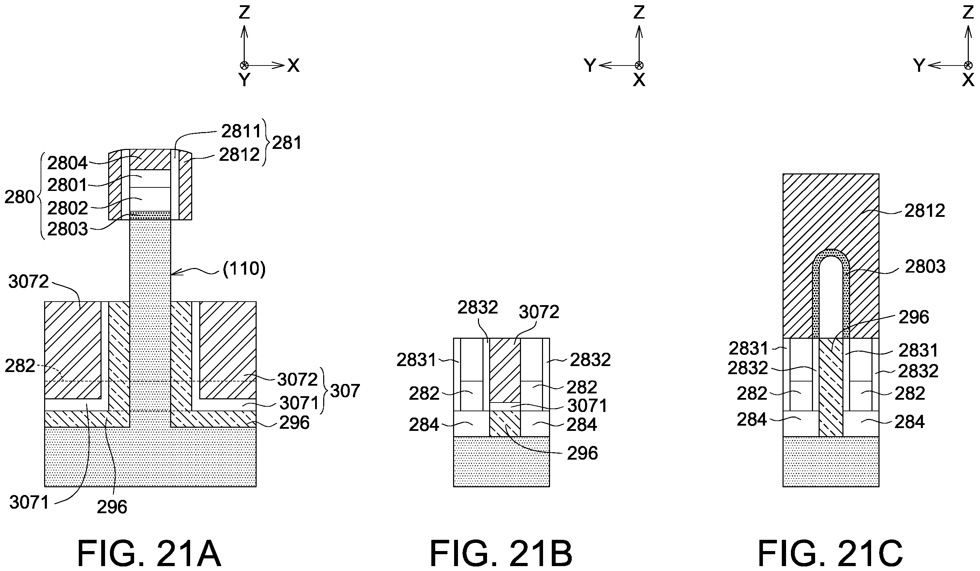

FIG. 21A to 21C shows schematic cross-sectional views of a structure at a stage of the manufacturing method, obtained by cutting the structure at different angles. The cross-sectional views of FIG. 18A and FIG. 21A are obtained at substantially the same angle and substantially the same position. The cross-sectional views of FIG. 18B and FIG. 21B are obtained at substantially the same angle and substantially the same position. The cross-sectional views of FIG. 18C and FIG. 21C are obtained at substantially the same angle and substantially the same position. Referring to FIGS. 21A to 21C, the revealed portion of the thermal oxide layer 296 is removed through an etching process to expose a portion of the vertical sidewall of the active region with the crystalline orientation (110).

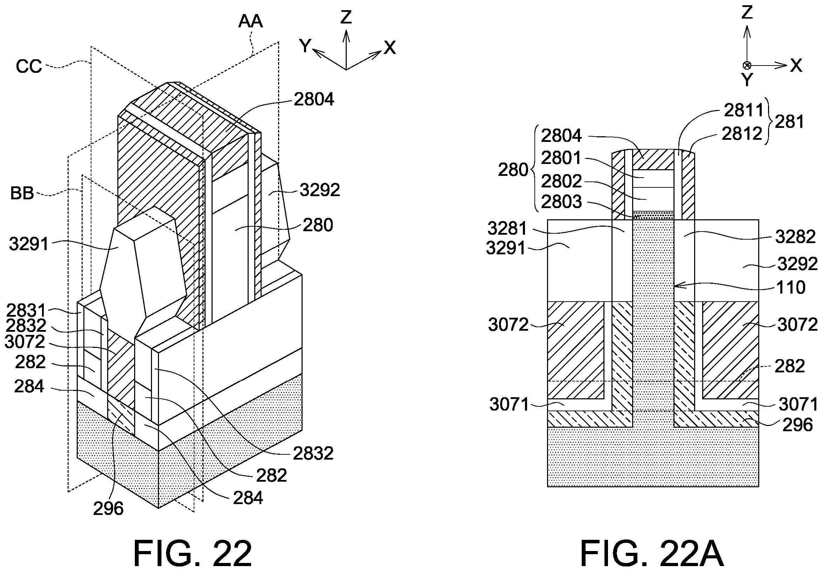

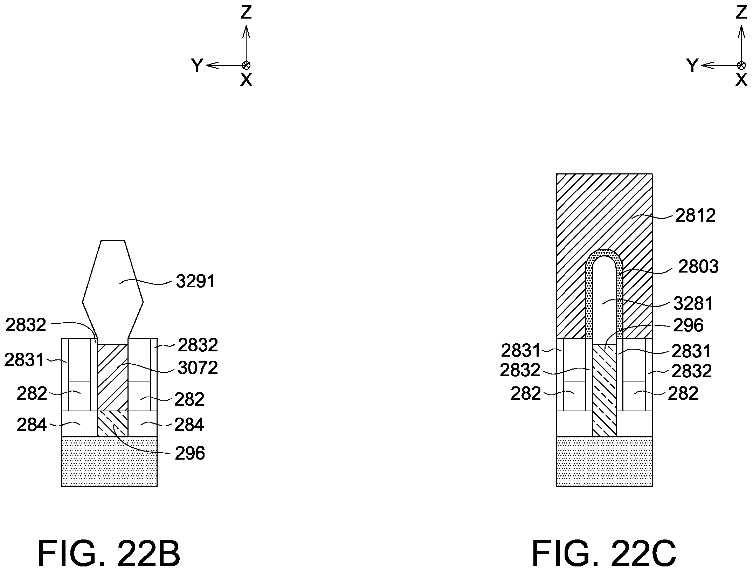

FIG. 22 illustrates a three-dimensional schematic view of a structure at a stage of the manufacturing method, FIG. 22A shows a schematic cross-sectional view of the structure illustrated along the lines AA shown in FIG. 22, FIG. 22B shows a schematic cross-sectional view of the structure illustrated along the lines BB shown in FIG. 22, and FIG. 22C shows a schematic cross-sectional view of the structure illustrated along the lines CC shown in FIG. 22. Referring to FIGS. 22 to 22C, based on the exposed portion of the vertical sidewall of the active region with the crystalline orientation (110), a first lightly doped region 3281, a second lightly doped region 3282, a first conductive region (or first heavily doped region) 3291 and a second conductive region (or second heavily doped region) 3292 are formed through a selective epitaxy growth (SEG) process. The exposed portion of the vertical sidewall of the active region may be right under the spacer structure 281. The first lightly doped region 3281 and the second lightly doped region 3282 can be formed on the exposed portion of the vertical sidewall of the active region and under the spacer structure 281. The first lightly doped region 3281 can abut on the first conductive region 3291. The second lightly doped region 3282 can abut on the second conductive region 3292. The first conductive region 3291 is connected to (or contact) the connecting plug 307 which is then connected to the UGI structure 282, and therefore, the UGI structure 282 is electrically connected to the first conductive region 3291 through the connecting plug 307. The second conductive region 3292 is connected to (or contact) the connecting plug 307 connected to the UGI structure 282, and therefore, the UGI structure 282 is electrically connected to the second conductive region 3292 through the connecting plug 307. The first lightly doped region 3281 and the second lightly doped region 3282 may include doped semiconductor materials such as N-type silicon. The first conductive region 3291 and the second conductive region 3292 may also include doped semiconductor materials such as N-type silicon. The first conductive region 3291 and the second conductive region 3292 may be highly doped. The first conductive region 3291 can be functioned as one of the source and drain of the FinFET, and the second conductive region 3292 can be functioned as the other one of the source and drain of the FinFET. In an embodiment, after the formation of the structure shown in FIG. 22, a conventional gate-last process can be performed to replace the dummy gate structure 280 with a gate structure of the FinFET and the formation of the FinFET can be completed. The FINFET can include a channel region defined between the drain and the source.

### <Second connection embodiment>

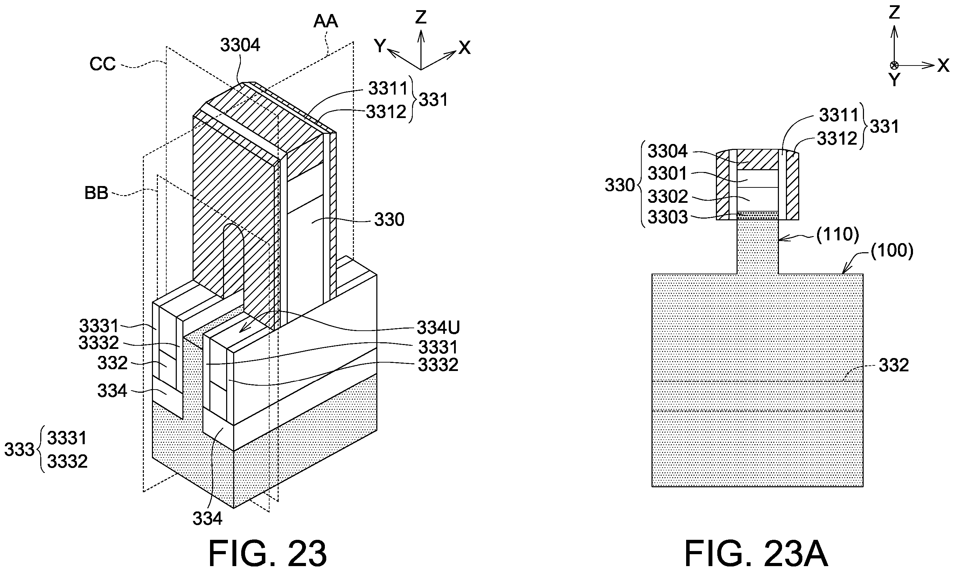

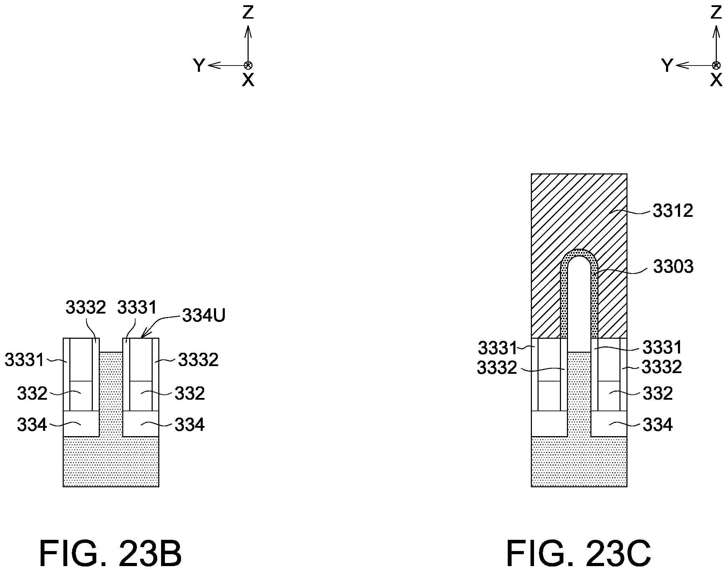

FIGS. 23 to 26 illustrate a method for electrically connecting an underground interconnection structure to a transistor according to this embodiment of the present disclosure. In an embodiment, the manufacturing steps illustrated with reference to FIGS. 23 to 26 can be performed after the manufacturing steps illustrated with reference to FIGS. 1A to 9 or the manufacturing steps illustrated with reference to FIGS. 10A to 17C.

FIG. 23 illustrates a three-dimensional schematic view of a structure at a stage of the manufacturing method, FIG. 23A shows a schematic cross-sectional view of the structure illustrated along the lines AA shown in FIG. 23, FIG. 23B shows a schematic cross-sectional view of the structure illustrated along the lines BB shown in FIG. 23, and FIG. 23C shows a schematic cross-sectional view of the structure illustrated along the lines CC shown in FIG. 23. Referring to FIGS. 23 to 23C, after forming the structure including the UGI structure 332 protected by asymmetric spacers 333 in the STI region 334, a dummy gate structure 330 and a spacer structure 331 covering sidewalls of the dummy gate structure 330 are formed based on standard foundry processes, and a portion of active region (or fin structure) outside the spacer structure 331 and above the top surface 334U of the STI region 334 will be revealed. The dummy gate structure 330 may include a cap nitride layer 3304, a cap oxide layer 3301, a semiconductor layer 3302, and a high-k dielectric layer 3303 stacked along the Z direction. The cap oxide layer 3301 may include oxide. The semiconductor layer 3302 may include a semiconductor material such as polycrystalline silicon. The high-k dielectric layer 3303 may include a dielectric material with a high dielectric constant. The spacer structure 331 may be a composite of a first spacer material 3311 and a second spacer material 3312 different from the first spacer material 3311, just like the spacer structure 281 described in FIG. 18 and the detailed of which is skipped. The UGI structure 332 can be the tungsten layer 1305 with TiN layer shown in FIG. 8C or in FIG. 17C. The STI region 334 can be the STI region 1214 shown in FIG. 8C or the STI region 2214 shown in FIG. 17C. The asymmetric spacers 333 includes a first spacer 3331 on a first side of the UGI structure 332 and a second spacer 3332 on a second side of the UGI structure 332, just like the asymmetric spacers 283 in FIG. 18 and the detailed of which is skipped.

Then, such revealed active region above the top surface 334U of the STI region 334 is removed by an etching process, such that a horizontal surface of the active region with a crystalline orientation (100) close to the top surface 334U of the STI region 334 is revealed, a vertical sidewall of the active region with a crystalline orientation (110) right under the spacer structure 331 covering the dummy gate structure 330 is revealed, and a top surface of the first spacer 3331 is exposed as well. The horizontal surface of the active region with the crystalline orientation (100) can be lower than the top surface 334U of the STI region 334 and higher than the upper surface of the UGI structure 332 in the Z direction.

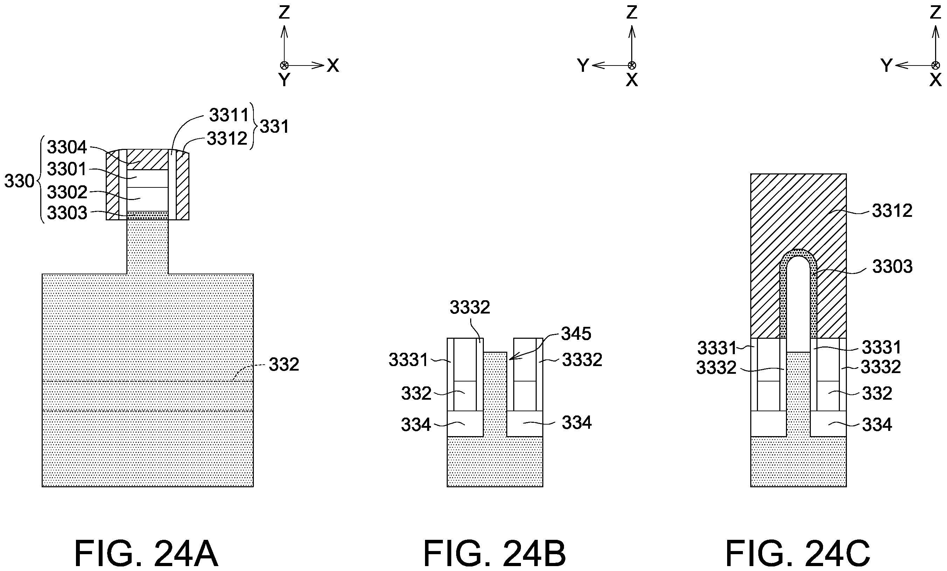

FIG. 24A to 24C shows schematic cross-sectional views of a structure at a stage of the manufacturing method, obtained by cutting the structure at different angles. The cross-sectional views of FIG. 23A and FIG. 24A are obtained at substantially the same angle and substantially the same position. The cross-sectional views of FIG. 23B and FIG. 24B are obtained at substantially the same angle and substantially the same position. The cross-sectional views of FIG. 23C and FIG. 24C are obtained at substantially the same angle and substantially the same position. Referring to FIGS. 24A to 24C, based on the exposed top surface of the first spacer 3331, the first spacer 3331, outside the spacer structure 331 covering the dummy gate structure 330, is removed by an etching process, such that a thin slot 345 is formed within the STI region 334 to reveal the sidewall of the UGI structure 332, and the second spacer 3332 is retained (see FIG. 24B). In an embodiment, if a nitride spacer (e.g. the TiN layer 1303 shown in FIG. 8C or 2303 shown in FIG. 17C) is used, the nitride spacer will be removed together with the first spacer 3331. A portion of the fin structure is exposed in the thin slot 345.

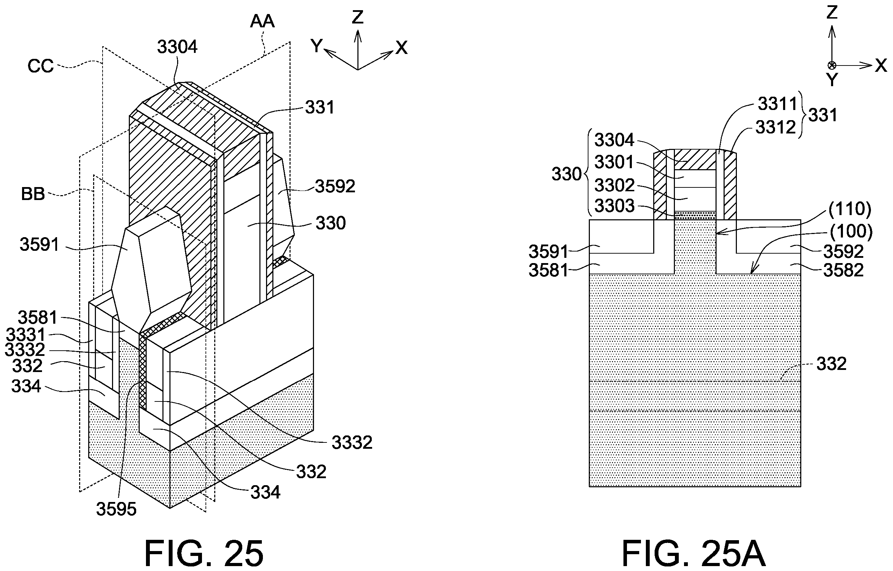

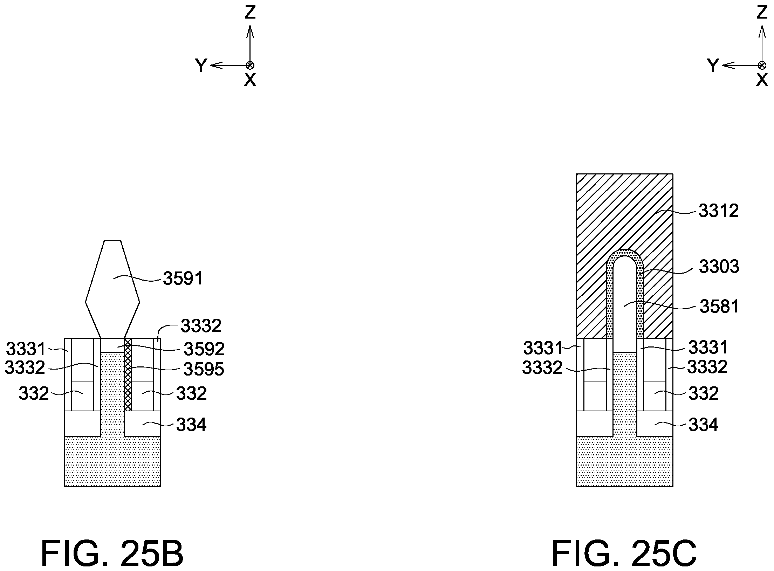

FIG. 25 illustrates a three-dimensional schematic view of a structure at a stage of the manufacturing method, FIG. 25A shows a schematic cross-sectional view of the structure illustrated along the lines AA shown in FIG. 25, FIG. 25B shows a schematic cross-sectional view of the structure illustrated along the lines BB shown in FIG. 25, and FIG. 25C shows a schematic cross-sectional view of the structure illustrated along the lines CC shown in FIG. 25. Referring to FIGS. 25 to 25C, a connecting plug 3595 is formed in the thin slot 345 through an atomic layer deposition process. The connecting plug 3595 can contact the revealed sidewall of the UGI structure 332. The connecting plug 3595 can be formed along the sidewall of the active region and within the STI region 334. The connecting plug 3595 may include a conductive material, such as titanium nitride formed by ALD (atomic layer deposition).

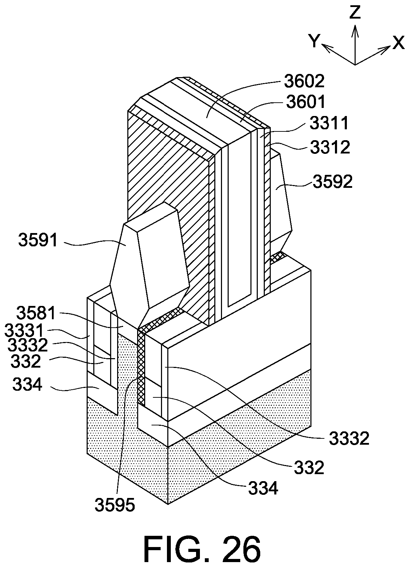

Then, based on the revealed horizontal surface of the active region with the crystalline orientation (100) and the revealed vertical sidewall of the active region with the crystalline orientation (110), a first lightly doped semiconductor region 3581, a second lightly doped semiconductor region 3582, a first heavily doped semiconductor region 3591 and a second heavily doped semiconductor region 3592 are formed through a selective epitaxy growth (SEG) process. The first lightly doped semiconductor region 3581 and the second lightly doped semiconductor region 3582 can be formed on and/or contact the revealed horizontal surface of the active region with the crystalline orientation (100) and the revealed vertical sidewall of the active region with the crystalline orientation (110). The first heavily doped semiconductor region 3591 can abut on the first lightly doped semiconductor region 3581. The second heavily doped semiconductor region 3592 can abut on the second lightly doped semiconductor region 3582. The UGI structure 332 is electrically connected to the first heavily doped semiconductor region 3591. In another example, the UGI structure 332 is electrically connected to the second heavily doped semiconductor region 3592. The first lightly doped semiconductor region 3581 and the second lightly doped semiconductor region 3582 may include doped semiconductor materials such as N-type silicon. The first heavily doped semiconductor region 3591 and the second heavily doped semiconductor region 3592 may include heavily doped semiconductor materials. In an embodiment, after the formation of the structure shown in FIG. 25, a conventional gate-last process can be performed to replace the dummy gate structure 330 with a gate structure of the FinFET and the formation of the FinFET can be completed. In an embodiment, the cap nitride layer 3304, the cap oxide layer 3301, the semiconductor layer 3302, the high-k dielectric layer 3303 are removed and replaced by a gate dielectric material 3601 and a gate conductive material 3602 so as to form the gate structure of the FinFET, as shown in FIG. 26. The FINFET can include a channel region defined between the drain and the source.

### <Third connection embodiment>

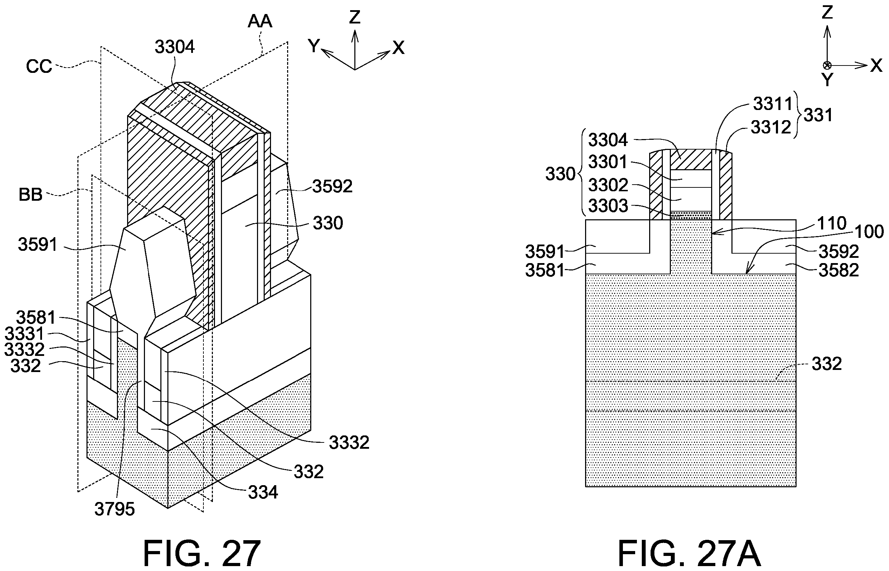

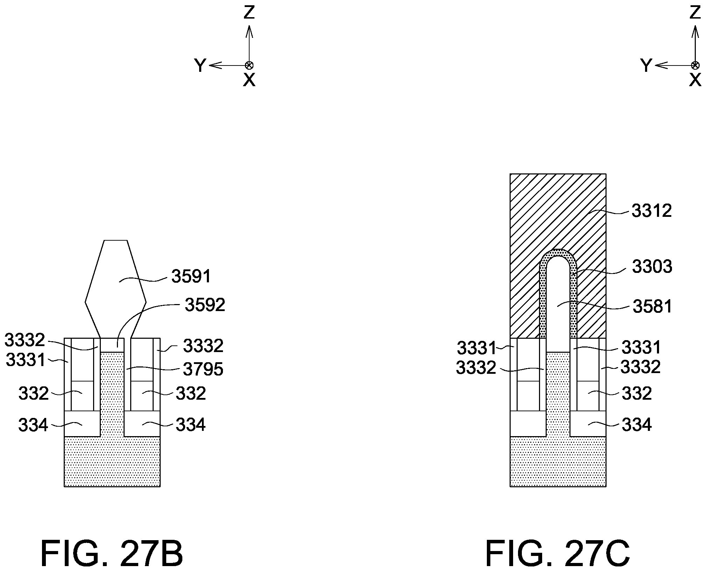

FIGS. 27 to 28 illustrate a method for electrically connecting an underground interconnection structure to a transistor according to this embodiment of the present disclosure. In an embodiment, the manufacturing steps illustrated with reference to FIGS. 27 to 28 can be performed after the manufacturing steps illustrated with reference to FIGS. 24A to 24C.

FIG. 27 illustrates a three-dimensional schematic view of a structure at a stage of the manufacturing method, FIG. 27A shows a schematic cross-sectional view of the structure illustrated along the lines AA shown in FIG. 27, FIG. 27B shows a schematic cross-sectional view of the structure illustrated along the lines BB shown in FIG. 27, and FIG. 27C shows a schematic cross-sectional view of the structure illustrated along the lines CC shown in FIG. 27.

Then, based on the revealed horizontal surface of the active region with the crystalline orientation (100) and the revealed vertical sidewall of the active region with the crystalline orientation (110), the first lightly doped semiconductor region 3581, the second lightly doped semiconductor region 3582, the first heavily doped semiconductor region 3591 and the second heavily doped semiconductor region 3592 are formed through a selective epitaxy growth (SEG) process. During the formation of the first heavily doped semiconductor region 3591, a connecting plug 3795 grown by the SEG with heavily doped semiconductor material could be also formed in the thin slot 345.

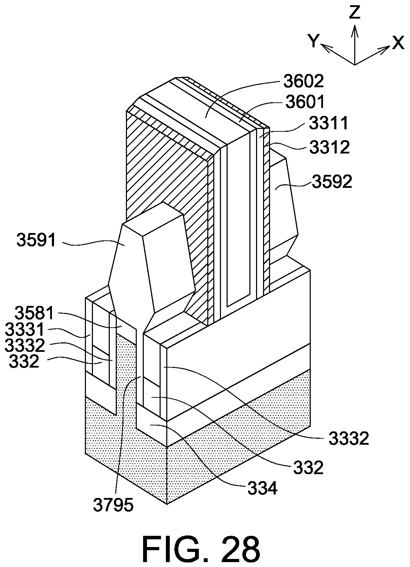

The first heavily semiconductor region 3591 and the connecting plug 3795 are electrically connected to each other, and therefore the UGI structure 332 is electrically connected to the first heavily doped semiconductor region 3591 through the connecting plug 3795. After the formation of the structure shown in FIG. 27, a conventional gate-last process can be performed to replace the dummy gate structure 330 with a gate structure of the FinFET and the formation of the FinFET can be completed, as shown in FIG. 28 and the detailed of which is described in FIG. 26.

### <Fourth connection embodiment>

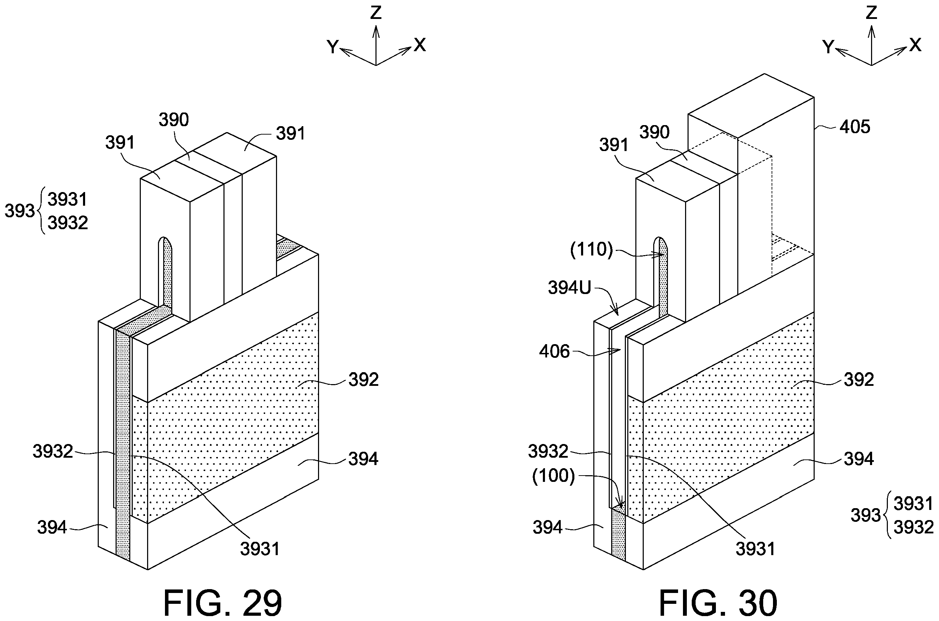

FIGS. 29 to 37A illustrate a method for electrically connecting an underground interconnection structure to a transistor according to this embodiment of the present disclosure. In an embodiment, the manufacturing steps illustrated with reference to FIGS. 29 to 37A can be performed after the manufacturing steps illustrated with reference to FIGS. 1A to 9 or the manufacturing steps illustrated with reference to FIGS. 10A to 17C.

FIG. 29 illustrates a three-dimensional schematic view of a structure at a stage of the manufacturing method. After forming the structure including the UGI structure 392 protected by asymmetric spacers 393 in the STI region 394, a dummy gate structure 390 and a spacer structure 391 covering sidewalls of the dummy gate structure 390 are formed based on standard foundry processes, and a portion of the active region (or fin structure) outside the spacer structure 391 will be revealed. The structure of the dummy gate structure 390 may be similar to that of the dummy gate structure 280 or 330. The spacer structure 391 may be similar to that of the spacer structure 281 or 331. The UGI structure 392 can be the tungsten layer 1305 with TiN layer shown in FIG. 8C or in FIG. 17C. The STI region 394 can be the STI region 1214 shown in FIG. 8C or the STI region 2214 shown in FIG. 17C. The asymmetric spacers 393 includes a first spacer 3931 on a first side of the UGI structure 392 and a second spacer 3932 on a second side of the UGI structure 392. The first spacer 3931 can be the SiOCN material 1209 shown in FIG. 8C or the SiOCN material 2209 shown in FIG. 17C. The second spacer 3932 can be the thermal oxide layer 1205 shown in FIG. 8C or the thermal oxide layer 2205 shown in FIG. 17C. A thickness of the spacer structure 391 in the X direction can be larger than a thickness of the spacer structure 281 and a thickness of the spacer structure 331. A width of the spacer structure 391 in the Y direction may be determined by the position of the UGI structure 392. Then, the active region not covered by the dummy gate structure 390 and the spacer structure 391 are partially removed, as shown in FIG. 29.

FIG. 30 illustrates a three-dimensional schematic view of a structure at a stage of the manufacturing method. A lithography pattering photomask 405 is formed to cover a first part of the revealed portion of the active region, and a second part of the revealed portion of the active region (which is not covered by the lithography pattering photomask 405, below the top surface 394U of the STI region 394 and made of silicon) is removed by an etching process to form a trench 406 within the active region. In the present embodiment, the first part and the second part of revealed portion of the active region can be on opposite sides of the dummy gate structure 390 in the X direction. The asymmetric spacers 393 are revealed by the trench 406. A vertical sidewall of the active region with a crystalline orientation (110) is under the spacer structure 391, and a horizontal surface of the active region with a crystalline orientation (100) is revealed by the trench 406.

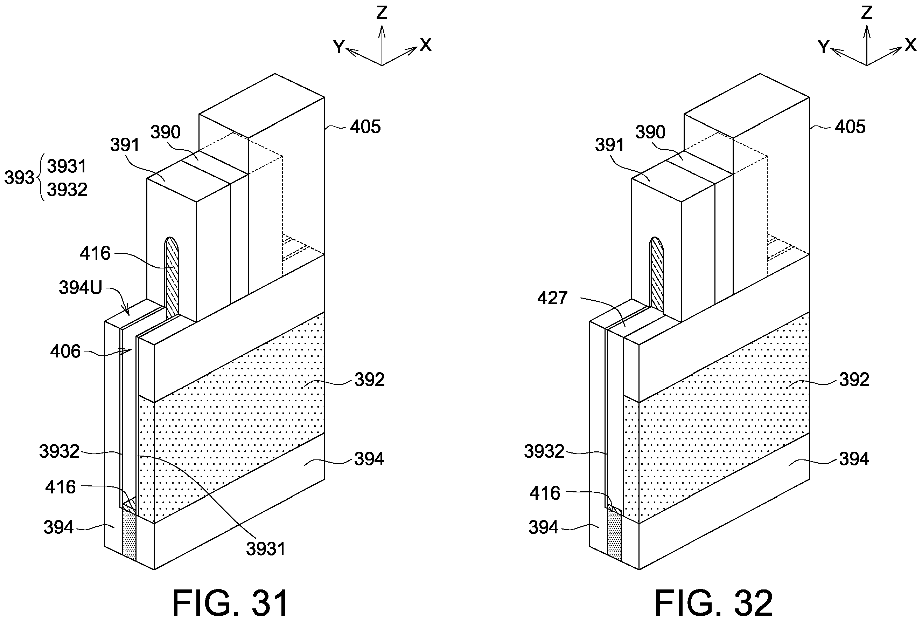

FIG. 31 illustrates a three-dimensional schematic view of a structure at a stage of the manufacturing method. A thermal oxide layer 416 is formed at the bottom of the trench 406 (i.e. on the horizontal surface of the active region with the crystalline orientation (100)) and on the vertical sidewall of the active region with a crystalline orientation (110) right under the spacer structure 391 through a thermal oxidation process.

FIG. 32 illustrates a three-dimensional schematic view of a structure at a stage of the manufacturing method. One of the asymmetric spacers 393, the first spacer 3931, exposed by the trench 406 is removed by an etching process to reveal the sidewall of the UGI structure 392, and the second spacer 3932 is retained. After the sidewall of the UGI structure 392 is revealed, a connecting plug 427 is formed in the trench 406 to connect the revealed sidewall of the UGI structure 392. In an embodiment, the connecting plug 427 can include a TiN film and a conductive film which may include or be made of tungsten (W). In this case, the connecting plug 427 self-aligned to the UGI structure 392 is formed within the active region.

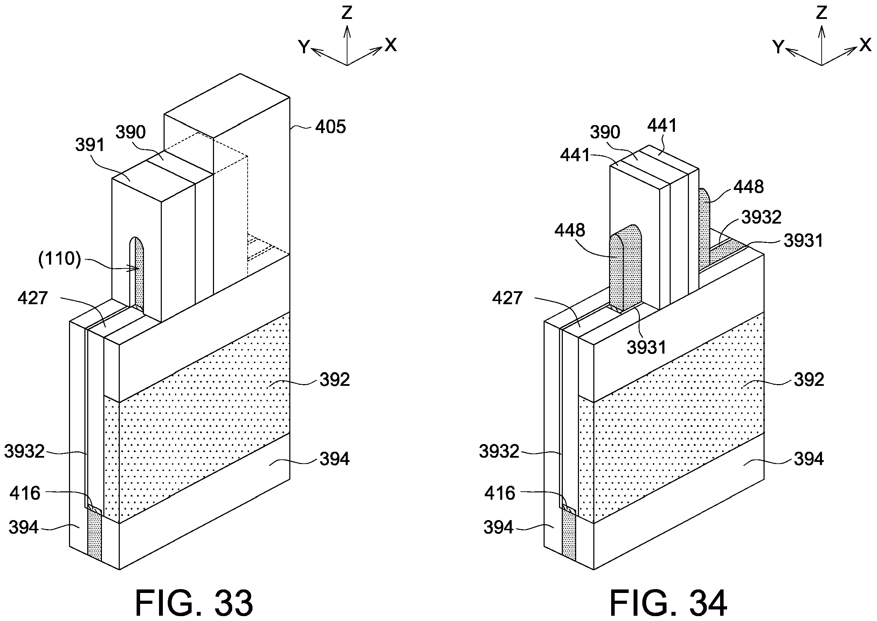

FIG. 33 illustrates a three-dimensional schematic view of a structure at a stage of the manufacturing method. A portion of the thermal oxide layer 416 covering the vertical sidewall of the active region with the crystalline orientation (110) is removed through an etching process, and a portion of the vertical sidewall of the active region above the top surface 394U of the STI region 394 is exposed.

FIG. 34 illustrates a three-dimensional schematic view of a structure at a stage of the manufacturing method. The lithography pattering photomask 405 is removed. The thickness of the spacer structure 391 in the X direction can be reduced to form a spacer structure 441 base on the electrical performance request and UGI process window, and an extra portion 448 of the fin structure outside the spacer structure 441 is exposed. In another embodiment, the spacer structure 441 is not formed by thinning the spacer structure 391, but by removing the spacer structure 391 and then using a low-k dielectric material to form the spacer structure 441.

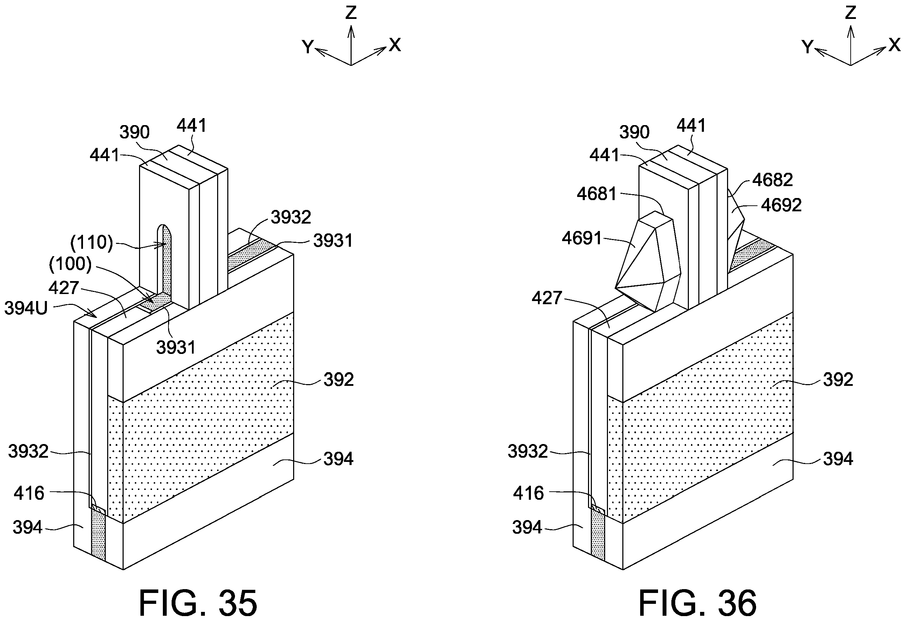

FIG. 35 illustrates a three-dimensional schematic view of a structure at a stage of the manufacturing method. The extra portion 448 of the fin structure, which may be made of silicon, can be removed through an anisotropic etching process, and a horizontal surface of the active region with the crystalline orientation (100) close to the top surface 394U surface of the STI region 394 and a vertical sidewall of the active region with the crystalline orientation (110) right under the spacer structure 441 are revealed. The revealed vertical sidewall of the active region can be slightly recessed relative to the surface of the spacer structure 441.

FIG. 36 illustrates a three-dimensional schematic view of a structure at a stage of the manufacturing method. Based on the revealed horizontal surface of the active region with the crystalline orientation (100) and the revealed vertical sidewall of the active region with the crystalline orientation (110) right under the spacer structure 441, a first lightly doped region 4681, a second lightly doped region 4682, a first conductive region (or a first heavily doped semiconductor region) 4691 and a second conductive region (or a second heavily doped semiconductor region) 4692 are formed through a selective epitaxy growth (SEG) process, and the formation of the source and drain of the FinFET is completed. Therefore, the UGI structure 392 is electrically connected to the first conductive region 4691 through the connecting plug 427.

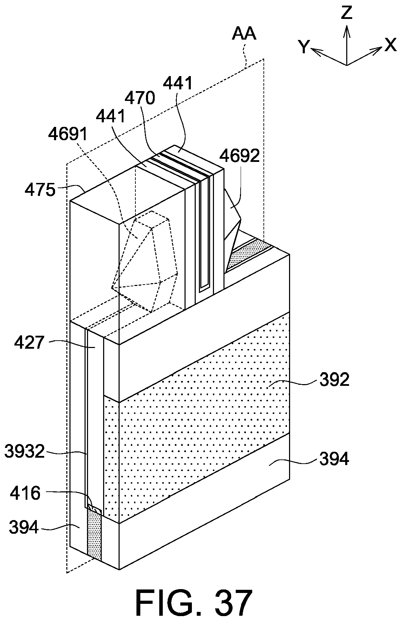

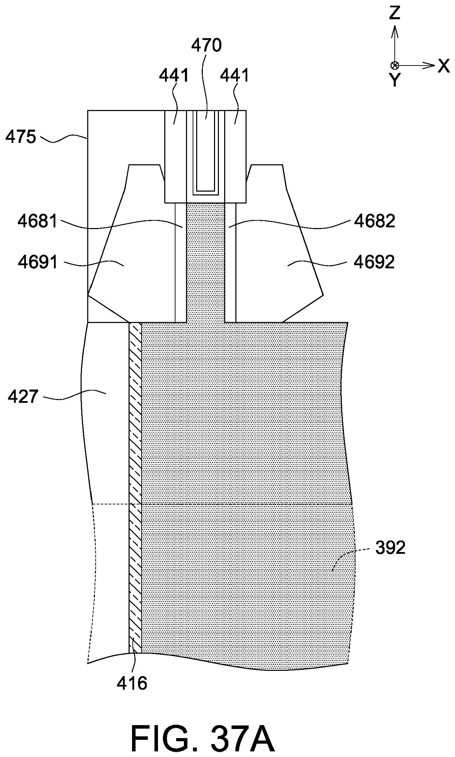

FIG. 37 illustrates a three-dimensional schematic view of a structure at a stage of the manufacturing method, FIG. 37A shows a schematic cross-sectional view of the structure illustrated along the lines AA shown in FIG. 37. The dummy gate structure 390 is replaced by a true gate structure 470 of the FinFET. For example, the true gate structure 470 of the FinFET can be a high-k metal gate (HKMG) structure. A metal cap (M0) 475 covering the first conductive region 4691 can be formed through a conventional metal zero (M0) layer process to further connect the first conductive region 4691 and the connection plug 427 in order to reduce the contacting resistance. Therefore, the conventional FinFET with the connection plug 427 to the UGI structure 392 is completed. The FINFET can include a channel region defined between the drain and the source. The metal cap 475 may include a titanium nitride (TiN) layer and a tungsten (W) layer on the titanium nitride layer.

### <Fifth connection embodiment>

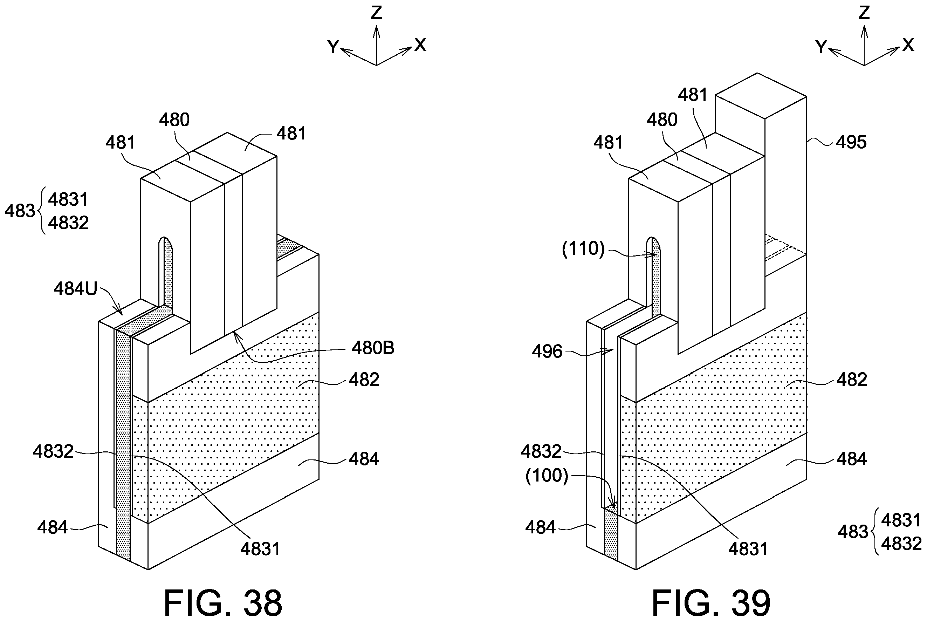

FIGS. 38 to 48A illustrate a method for electrically connecting an underground interconnection structure to a transistor according to some embodiments of the present disclosure. In an embodiment, the manufacturing steps illustrated with reference to FIGS. 38 to 48A can be performed after the manufacturing steps illustrated with reference to FIGS. 1A to 9 or the manufacturing steps illustrated with reference to FIGS. 10A to 17C.

FIG. 38 illustrates a three-dimensional schematic view of a structure at a stage of the manufacturing method. After forming the structure including the UGI structure 482 protected by asymmetric spacers 483 in the STI region 484, a dummy gate structure 480 and a spacer structure 481 covering sidewalls of the dummy gate structure 480 are formed based on standard foundry processes, and a portion of the active region (or fin structure) outside the spacer structure 481 will be partially removed. The structure of the dummy gate structure 480 may be similar to that of the dummy gate structure 280 or 330. The structure of the spacer structure 481 may be similar to that of the spacer structure 281 or 331. The UGI structure 482 can be the tungsten layer 1305 shown in FIG. 8C or the tungsten layer 2305 shown in FIG. 17C. The STI region 484 can be the STI region 1214 shown in FIG. 8C or the STI region 2214 shown in FIG. 17C. The asymmetric spacers 483 includes a first spacer 4831 on a first side of the UGI structure 482 and a second spacer 4832 on a second side of the UGI structure 482. A bottom 480B of the dummy gate structure 480 at the STI region 484 is lower than the top surface 484U of the STI region 484.

FIG. 39 illustrates a three-dimensional schematic view of a structure at a stage of the manufacturing method. A lithography pattering photomask 495 is formed to cover a first part of the revealed portion of the active region, and a second part of the revealed portion of the active region (which is not covered by the lithography pattering photomask 495, below the top surface 484U of the STI region 484 and made of silicon) is further etched down by an etching process to form a trench 496 within the active region. The asymmetric spacers 483 are revealed by the trench 496. A vertical sidewall of the active region with a crystalline orientation (110) and a horizontal surface of the active region with a crystalline orientation (100) are revealed by the trench 496.

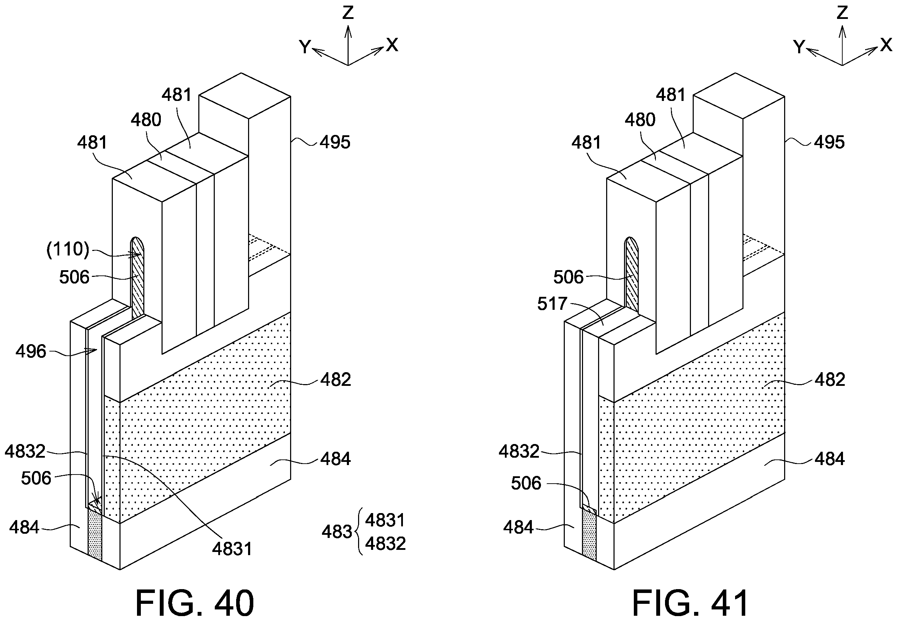

FIG. 40 illustrates a three-dimensional schematic view of a structure at a stage of the manufacturing method. A thermal oxide layer 506 is formed at the bottom of the trench 496 (i.e. on the horizontal surface of the active region with the crystalline orientation (100)) and on the vertical sidewall of the active region with a crystalline orientation (110) right under the spacer structure 481 through a thermal oxidation process.

FIG. 41 illustrates a three-dimensional schematic view of a structure at a stage of the manufacturing method. One of the asymmetric spacers 483, the first spacer 4831, exposed by the trench 496 is removed by an etching process to reveal the sidewall of the UGI structure 482, and the second spacer 4832 is retained. After the sidewall of the UGI structure 482 is revealed, a connecting plug 517 is formed in the trench 496 to connect the revealed sidewall of the UGI structure 482. In an embodiment, the connecting plug 517 can include a TiN film and a conductive film which may include or be made of tungsten (W).

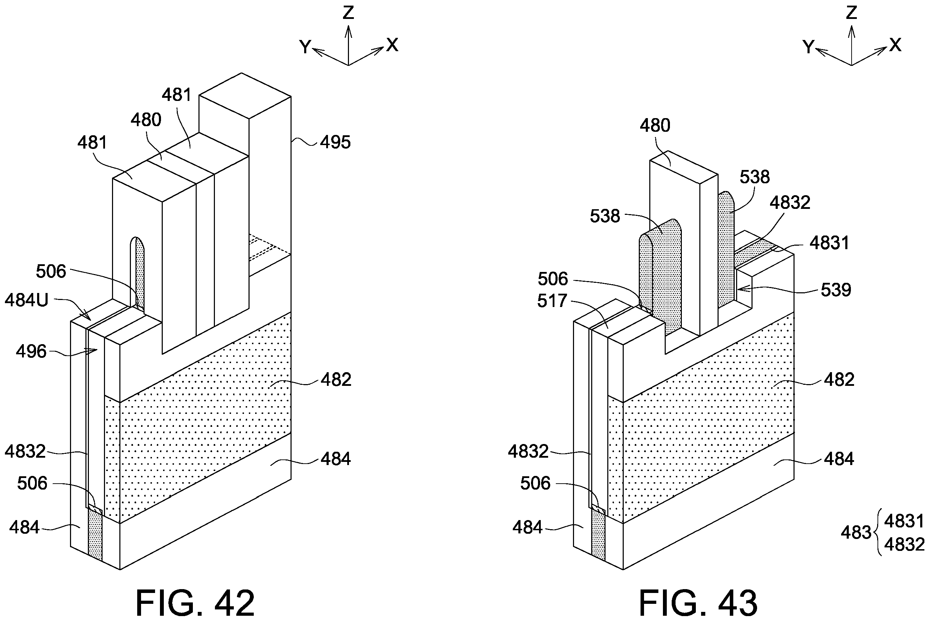

FIG. 42 illustrates a three-dimensional schematic view of a structure at a stage of the manufacturing method. A portion of the thermal oxide layer 506 covering the vertical sidewall of the active region with the crystalline orientation (110) is removed through an etching process, and a portion of the vertical sidewall of the active region above the top surface 484U of the STI region 484 is exposed.

FIG. 43 illustrates a three-dimensional schematic view of a structure at a stage of the manufacturing method. The lithography pattering photomask 495 is removed. The spacer structure 481 on opposite sides of the dummy gate structure 480 can be removed to form the structure shown in FIG. 43. In the structure shown in FIG. 43, an extra portion 538 of the fin structure outside the dummy gate structure 480 is exposed, and concaves 539 are formed in the STI region 484. A sidewall of the dummy gate structure 480 and a sidewall of the extra portion 538 can be exposed by the concave 539. The concaves 539 can be on opposite sides of the dummy gate structure 480. In another embodiment, the thickness of the removed spacer structure 481 in the X direction can be reduced to form a thinner spacer structure to redefine a length of a channel region base on the electrical performance request and UGI process window.

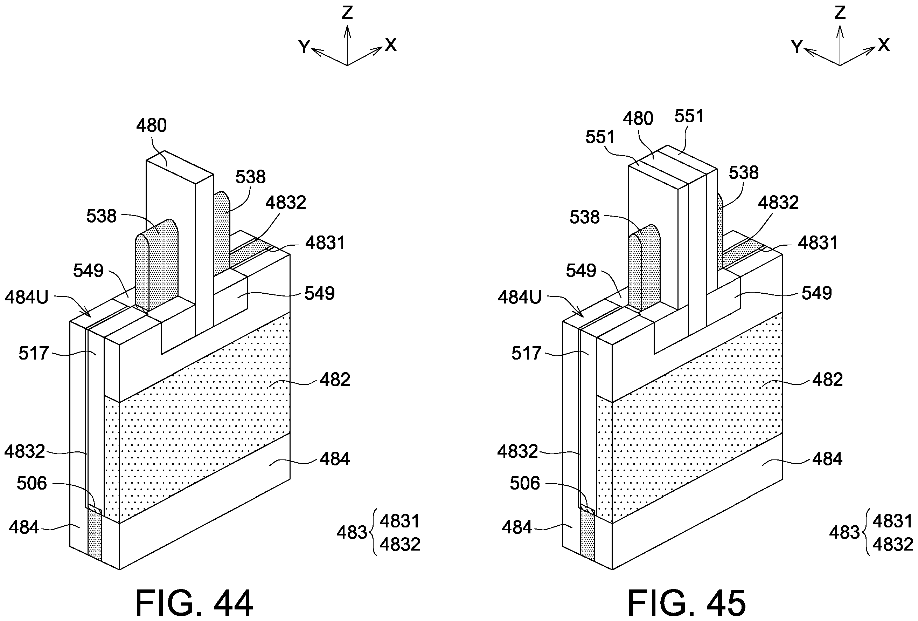

FIG. 44 illustrates a three-dimensional schematic view of a structure at a stage of the manufacturing method. Dielectric elements 549 can be formed in the concaves 539 through a deposition process and an etching back process. A top surface of the dielectric element 549 can be align with or coplanar with the top surface 484U of the STI region 484.

FIG. 45 illustrates a three-dimensional schematic view of a structure at a stage of the manufacturing method. A spacer structure 551 is formed on opposite sides of the dummy gate structure 480 and above the dielectric elements 549 to redefine a length of a channel region base on the electrical performance request and UGI process window. The spacer structure 551 can cover opposite sidewalls of the dummy gate structure 480. The spacer structure 551 may include or be made of low-k dielectric material.

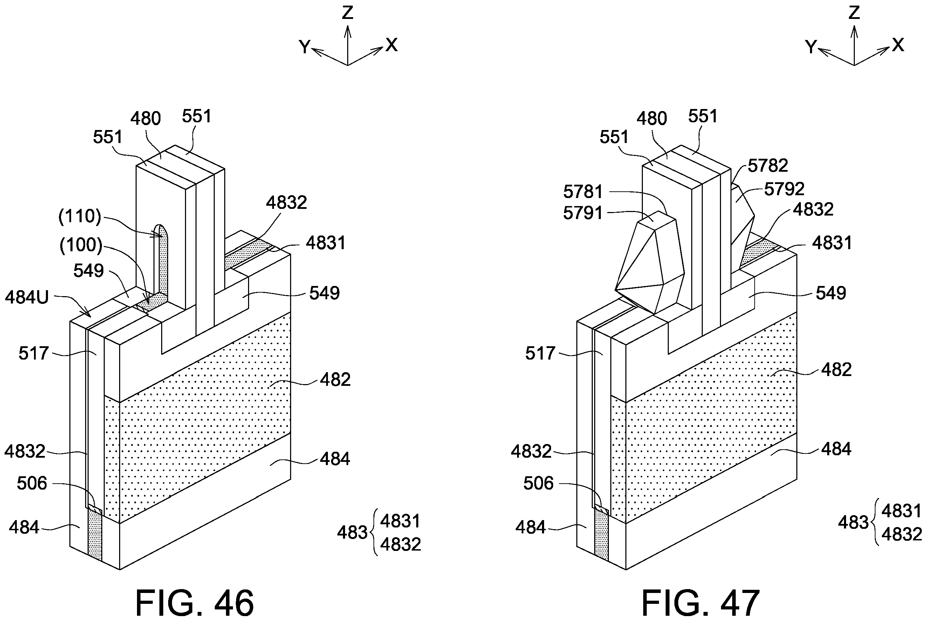

FIG. 46 illustrates a three-dimensional schematic view of a structure at a stage of the manufacturing method. A portion of the fin structure, which may be made of silicon and is not covered by the spacer structure 551, can be removed through an anisotropic etching process, and a horizontal surface of the active region with the crystalline orientation (100) close to the top surface 484U surface of the STI region 484 and a vertical sidewall of the active region with the crystalline orientation (110) right under the spacer structure 551 are revealed.

FIG. 47 illustrates a three-dimensional schematic view of a structure at a stage of the manufacturing method. Based on the revealed horizontal surface of the active region with the crystalline orientation (100) and the revealed vertical sidewall of the active region with the crystalline orientation (110) right under the spacer structure 551, a first lightly doped region 5781, a second lightly doped region 5782, a first conductive region (or a first heavily doped semiconductor region) 5791 and a second conductive region (or a second heavily doped semiconductor region) 5792 are formed through a selective epitaxy growth (SEG) process, and the formation of the source and drain of the FinFET is completed, as previously mentioned. The first conductive region 5791 is connected to (or contact) the connecting plug 517 connected to the UGI structure 482; therefore, the UGI structure 482 is electrically connected to the first conductive region 5791 through the connecting plug 517.

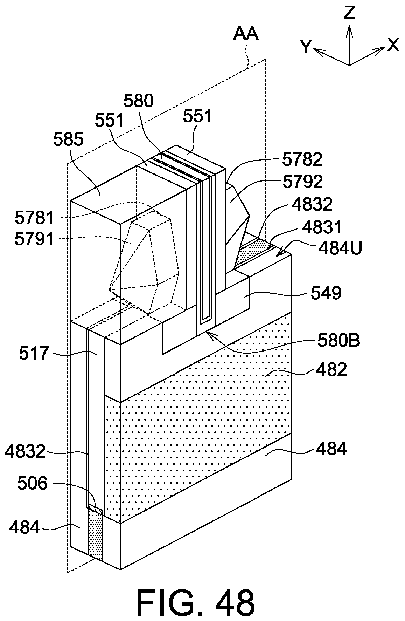

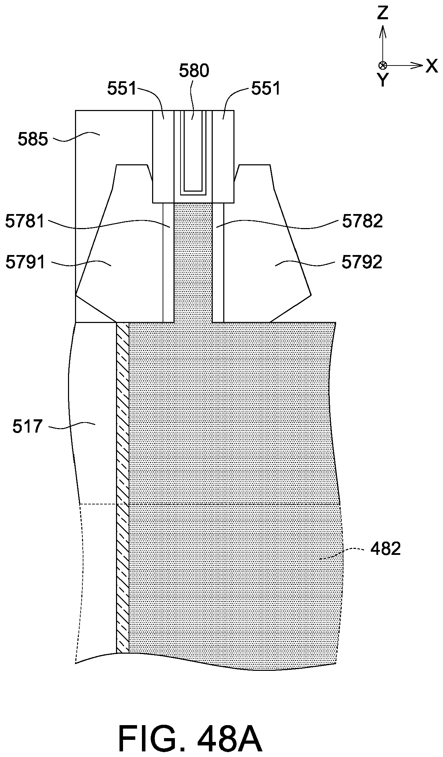

FIG. 48 illustrates a three-dimensional schematic view of a structure at a stage of the manufacturing method, FIG. 48A shows a schematic cross-sectional view of the structure illustrated along the lines AA shown in FIG. 48. The dummy gate structure 480 is replaced by a true gate structure 580 of the FinFET. For example, the true gate structure 580 of the FinFET can be a high-k metal gate (HKMG). The bottom 580B of the gate structure 580 at the STI region 484 is lower than the bottoms of the first conductive region 5791 and the second conductive region 5792. A metal cap (M0) 585 covering the first conductive region 5791 can be formed through a conventional metal zero (M0) layer process to further connect the first conductive region 5791 and the connection plug 517 in order to reduce the contacting resistance. Therefore, the conventional FinFET with the connection plug 517 to the UGI structure 482 is completed.

### <Sixth connection embodiment>

The following content uses a GAA transistor as an example to illustrate how to electrically connect the UGI structure to the source terminal or the drain terminal of the transistor. The source terminal or the drain terminal of the GAA transistor can be formed by a selective epitaxy growth process.

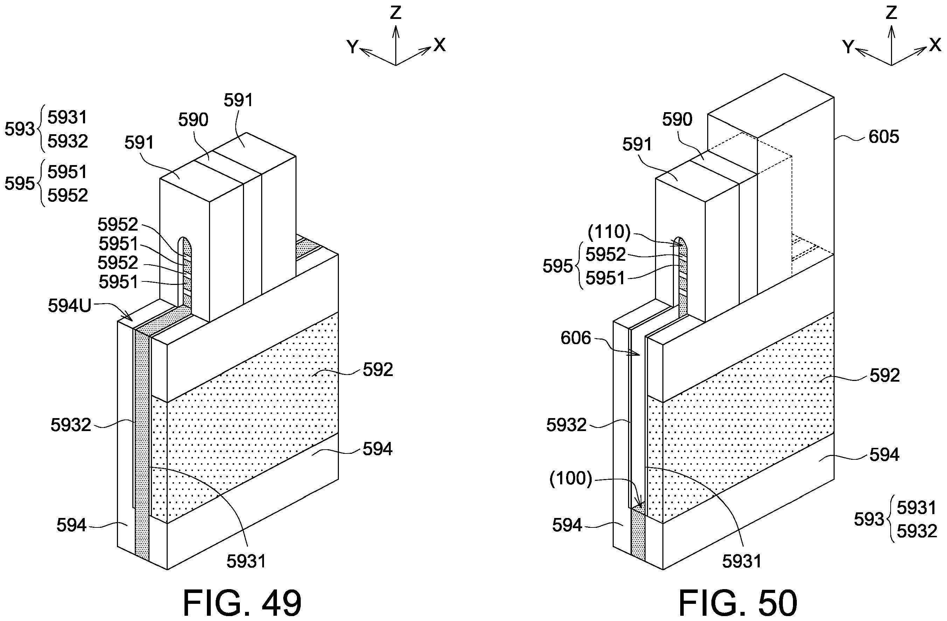

FIGS. 49 to 57A illustrate a method for electrically connecting an underground interconnection structure to a transistor according to some embodiments of the present disclosure. In an embodiment, the manufacturing steps illustrated with reference to FIGS. 49 to 57A can be performed after the manufacturing steps illustrated with reference to FIGS. 1A to 9 or the manufacturing steps illustrated with reference to FIGS. 10A to 17C. The method of this embodiment is different from the methods of the previous embodiments in that, the method of this embodiment includes exposing vertical sidewalls of the semiconductor nanosheets under the spacer structure of a GAA transistor (as shown in FIGS. 49 to 55), rather than exposing a vertical sidewall of the fin structure right under the spacer structure of a FinFET transistor (e.g., FIGS. 27 to 33).

FIG. 49 illustrates a three-dimensional schematic view of a structure at a stage of the manufacturing method. After forming the structure including the UGI structure 592 protected by asymmetric spacers 593 in the STI region 594, a dummy gate structure 590 on the nanosheet stack 595 and a spacer structure 591 covering sidewalls of the dummy gate structure 590 are formed based on standard foundry processes, and a portion of the active region outside the spacer structure 591 will be partially removed. The nanosheet stack 595 includes semiconductor nanosheets 5951 and sacrificial nanosheets 5952 alternately stacked along the Z direction. The material of the semiconductor nanosheet 5951 may be different from that of the sacrificial nanosheet 5952. The semiconductor nanosheet 5951 may include or be made of a semiconductor material such as silicon. The sacrificial nanosheet 5952 may include or be made of silicon germanium (SiGe). The nanosheet stack 595 may be formed by an epitaxial growth process. In the structure shown in FIG. 49, vertical sidewalls of the semiconductor nanosheets 5951 under the spacer structure 591 are exposed. The exposed vertical sidewalls of the semiconductor nanosheets 5951 can have a crystalline orientation (110). The structure of the dummy gate structure 590 may be similar to that of the dummy gate structure 280 or 330. The spacer structure 591 may not cover the upper surface of the dummy gate structure 590. The structure of the spacer structure 591 may be similar to that of the spacer structure 281 or 331. The UGI structure 592 can be the tungsten layer 1305 with TiN layer shown in FIG. 8C or the tungsten layer 2305 with TiN layer shown in FIG. 17C. The STI region 594 can be the STI region 1214 shown in FIG. 8C or the STI region 2214 shown in FIG. 17C. The asymmetric spacers 593 includes a first spacer 5931 on a first side of the UGI structure 592 and a second spacer 5932 on a second side of the UGI structure 592, as previously described. The nanosheet stack 595, the dummy gate structure 590 and the spacer structure 591 can be above the top surface 594U of the STI region 594.

FIG. 50 illustrates a three-dimensional schematic view of a structure at a stage of the manufacturing method. A lithography pattering photomask 605 is formed to cover a first part of the revealed portion of the active region, and a second part of the revealed portion of the active region (which is not covered by the lithography pattering photomask 605, below the top surface 594U of the STI region 594 and made of silicon) is further etched down by an etching process to form a trench 606 within the active region. The asymmetric spacers 593 are revealed by the trench 606. A vertical sidewall of the active region with a crystalline orientation (110) under the spacer structure 591 is revealed, and a horizontal surface of the active region with the crystalline orientation (100) are revealed by the trench 606.

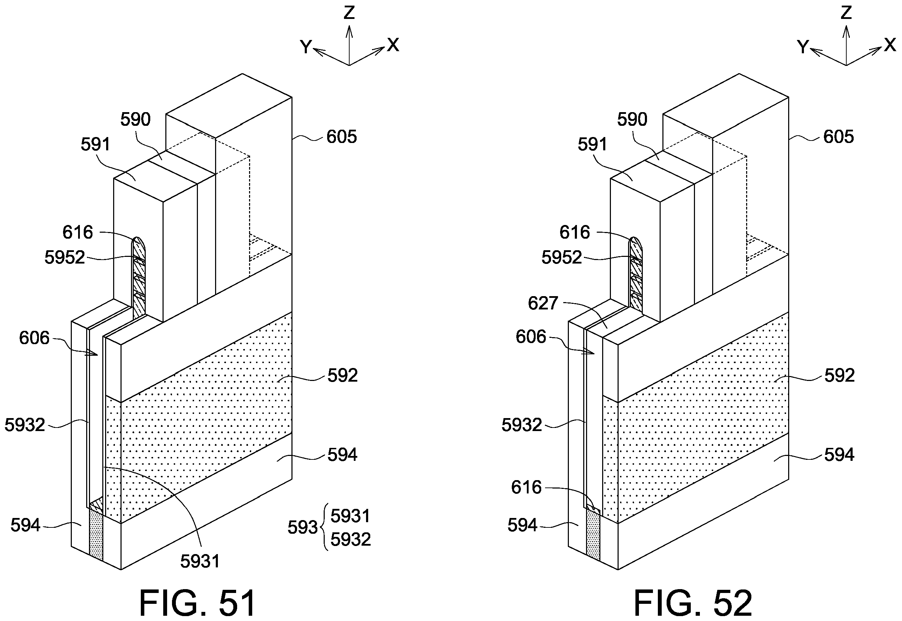

FIG. 51 illustrates a three-dimensional schematic view of a structure at a stage of the manufacturing method. A thermal oxide layer 616 is formed at the bottom of the trench 606 (i.e. on the horizontal surface of the active region), on the sidewall of the trench 606 (i.e. on the vertical sidewall of the active region right under the spacer structure 591) and on the exposed vertical sidewalls of the semiconductor nanosheets 5951 right under the spacer structure 591 through a thermal oxidation process.

FIG. 52 illustrates a three-dimensional schematic view of a structure at a stage of the manufacturing method. One of the asymmetric spacers 593, the first spacer 5931, exposed by the trench 606 is removed by an etching process to reveal the sidewall of the UGI structure 592, and the second spacer 5932 is retained. After the sidewall of the UGI structure 592 is revealed, a connecting plug 627 is formed in the trench 606 to connect the revealed sidewall of the UGI structure 592.

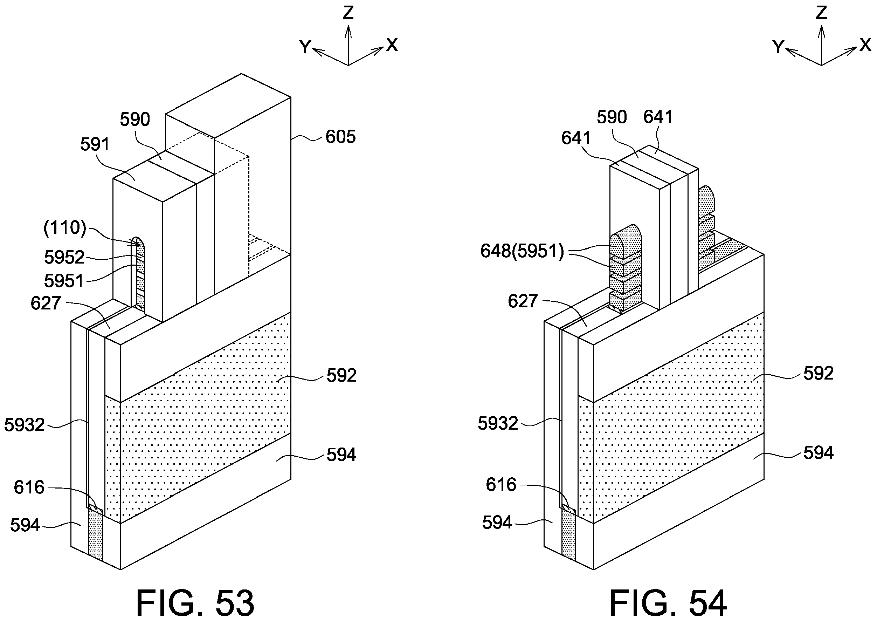

FIG. 53 illustrates a three-dimensional schematic view of a structure at a stage of the manufacturing method. A portion of the thermal oxide layer 616 covering the vertical sidewalls of the semiconductor nanosheets 5951 right under the spacer structure 591 is removed through an etching process, and the vertical sidewalls of the semiconductor nanosheets 5951 right under the spacer structure 591 with the crystalline orientation (110) is exposed.

FIG. 54 illustrates a three-dimensional schematic view of a structure at a stage of the manufacturing method. The lithography pattering photomask 605 is removed. The thickness of the spacer structure 591 in the X direction can be reduced to form a spacer structure 641 base on the electrical performance request and UGI process window, extra portions 648 of the semiconductor nanosheets 5951 outside the spacer structure 641 is exposed. The sacrificial nanosheets 5952 between the semiconductor nanosheets 5951 can be removed at this stage. In another embodiment, the spacer structure 641 is not formed by thinning the spacer structure 591, but by removing the spacer structure 591 and then using a low-k dielectric material to form the spacer structure 641.

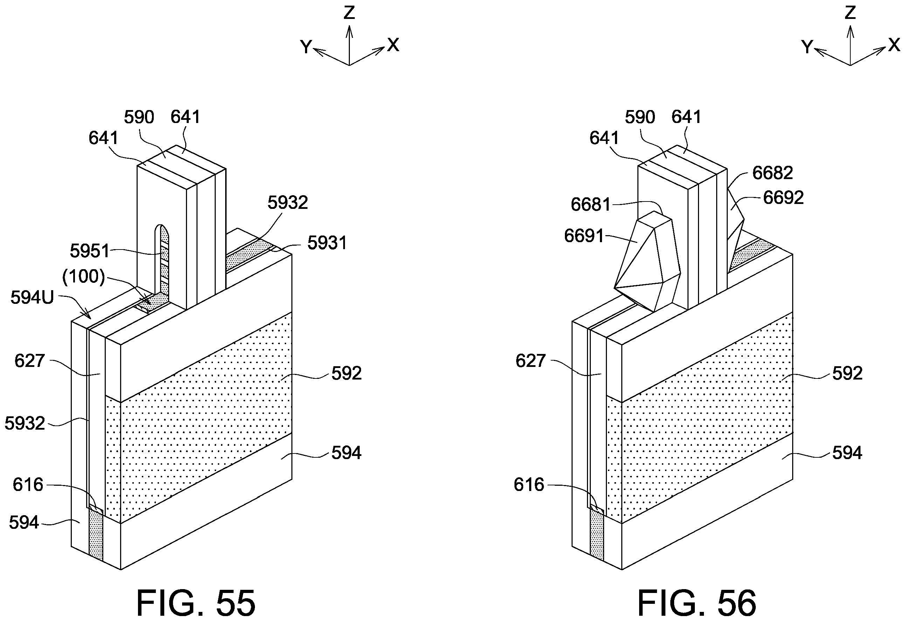

FIG. 55 illustrates a three-dimensional schematic view of a structure at a stage of the manufacturing method. The extra portion 648 of the semiconductor nanosheets 5951 can be removed through an anisotropic etching process, and a horizontal surface of the active region with the crystalline orientation (100) close to the top surface 594U surface of the STI region 594 and vertical sidewalls of the semiconductor nanosheets 5951 with the crystalline orientation (110) right under the spacer structure 641 are revealed. The revealed vertical sidewalls of the semiconductor nanosheets 5951 can be slightly recessed relative to the surface of the spacer structure 641.

FIG. 56 illustrates a three-dimensional schematic view of a structure at a stage of the manufacturing method. Based on the revealed horizontal surface of the active region with the crystalline orientation (100) and the revealed vertical sidewalls of the semiconductor nanosheets 5951 with the crystalline orientation (110), a first lightly doped region 6681, a second lightly doped region 6682, a first conductive region (or a first heavily doped semiconductor region) 6691 and a second conductive region (or a second heavily doped semiconductor region) 6692 are formed through a selective epitaxy growth (SEG) process as previously mentioned, and the formation of the source and drain of the GAA transistor is completed. The first lightly doped region 6681 and the second lightly doped region 6682 can be formed on and/or contact the revealed vertical sidewalls of the semiconductor nanosheets 5951. The first conductive region 6691 can be formed on the sidewall of the first lightly doped region 6681. The second conductive region 6692 can be formed on the sidewall of the second lightly doped region 6682. The first conductive region 6691 is connected to (or contact) the connecting plug 627 which is then connected to the UGI structure 592; therefore, the UGI structure 592 is electrically connected to the first conductive region 6691. The first conductive region 6691 can be functioned as one of the source and drain of the GAA transistor, and the second conductive region 6692 can be functioned as the other one of the source and drain of the GAA transistor.

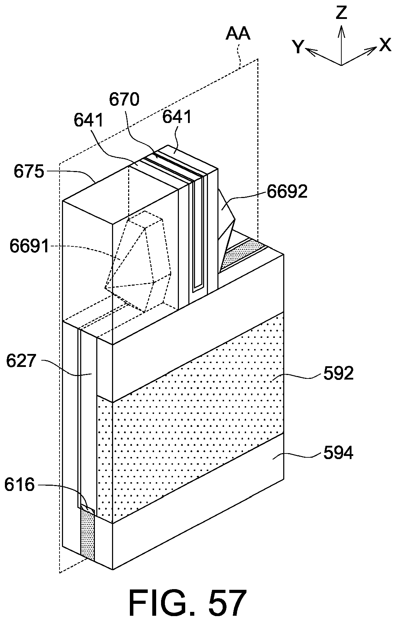

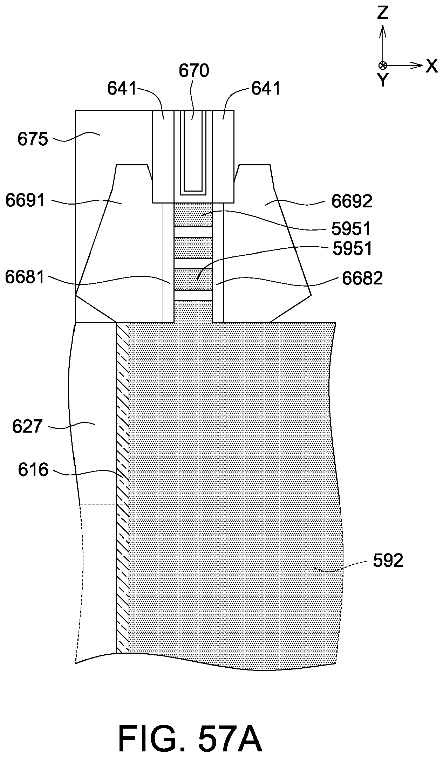

FIG. 57 illustrates a three-dimensional schematic view of a structure at a stage of the manufacturing method, FIG. 57A shows a schematic cross-sectional view of the structure illustrated along the lines AA shown in FIG. 57. The dummy gate structure 590 is replaced by a gate structure 670 of the GAA transistor. For example, the gate structure 670 of the GAA transistor can be a high-k metal gate (HKMG). A metal cap (M0) 675 covering the first conductive region 6691 can be formed through a conventional metal zero (M0) layer process to further connect the first conductive region 6691 and the connection plug 627 in order to reduce the contacting resistance. Therefore, the conventional GAA transistor with the connection plug 627 to the UGI structure 592 is completed.

With the underground interconnection structure and the connection plug (either within the active region or along the sidewall of the active region) connection the underground interconnection structure to the transistor (such as a planar transistor, a FinFET, a GAA transistor, or complementary FET (CFET)) of an integrated circuit, a middle side signal delivery network in the integrated circuit can be achieved. The underground interconnection structure and its connection according to the present disclosure can free the space in layout for the conventional metal layers above the original semiconductor surface, simplify the layout for the conventional metal layers above the original semiconductor surface, and reduce the IR drop for signal delivery. Moreover, a backside signal delivery can be efficiently achieved for the semiconductor circuit chip based on the underground interconnection structure and its connection to transistors of integrated circuit according to the present disclosure.

Moreover, the underground interconnection structure and its connection according to the present disclosure could be applied to heat dissipation network in the event the underground interconnection structure in the STI region comprises thermal dissipation material the thermal conductivity of which is higher than that of Si or SiO₂. Especially, the underground interconnection structure within the semiconductor substrate extends far away from active regions to other spare or big STI region above which the thermal vias could be disposed, or under which the through silicon vias could be disposed.

It is noted that the structures and methods as described above are provided for illustration. The disclosure is not limited to the configurations and procedures disclosed above. Other embodiments with different configurations of known elements can be applicable, and the exemplified structures could be adjusted and changed based on the actual needs of the practical applications. It is, of course, noted that the configurations of figures are depicted only for demonstration, not for limitation. Thus, it is known by people skilled in the art that the related elements and layers in a semiconductor structure, the shapes or positional relationship of the elements and the procedure details could be adjusted or changed according to the actual requirements and/or manufacturing steps of the practical applications.

While the disclosure has been described by way of example and in terms of the exemplary embodiment(s), it is to be understood that the disclosure is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A semiconductor device structure, comprising:
a semiconductor substrate with an original semiconductor surface and an active region;
a shallow trench isolation (STI) region (284, 334, 394, 484, 594) surrounding the active region;
a transistor formed based on the active region and comprising a gate structure (470, 580, 670), a first conductive region (3291, 3591, 4691, 5791, 6691, 3281, 3581, 4681, 5781, 6681), a second conductive region (3292, 3592, 4692, 5792, 6692, 3282, 3582, 4682, 5782, 6682), and a channel region between the first conductive region and the second conductive region, wherein the first conductive region comprises an epitaxial semiconductor material;
an interconnection structure (282, 332, 392, 482, 592) extending beyond the transistor, wherein the interconnection structure (282, 332, 392, 482, 592) is disposed under the original semiconductor surface and within the STI region (284, 334, 394, 484, 594); and
a connecting plug (307, 427, 517, 627, 3595, 3795) electrically connecting the interconnection structure (282, 332, 392, 482, 592) to the first conductive region of the transistor, wherein the connecting plug (307, 427, 517, 627) is within the active region and the epitaxial semiconductor material of the first conductive region is over a top surface of the connecting plug (307, 427, 517, 627), or the connecting plug (3595, 3795) is within the STI region (334) and the epitaxial semiconductor material of the first conductive region is connected to a first sidewall of the connecting plug (3595, 3795).

2. The semiconductor device structure of claim 1, wherein the interconnection structure (282, 332, 392, 482, 592) is isolated from the semiconductor substrate by an insulating region (283, 333, 393, 483, 593), the insulating region (283, 333, 393, 483, 593) comprises a first spacer (2831, 3331, 3931, 4831, 5931) on a first side of the interconnection structure (282, 332, 392, 482, 592) and a second spacer (2832, 3332, 3932, 4832, 5932) on a second side of the interconnection structure (282, 332, 392, 482, 592), and the material of the first spacer is different from that of the second spacer.

3. The semiconductor device structure of claim 1 or 2, wherein a second sidewall of the connecting plug (307, 427, 517, 627, 3595, 3795) is aligned with and contacts to a sidewall of the interconnection structure (282, 332, 392, 482, 592).

4. The semiconductor device structure of claim 3, further comprising
a trench (285, 406, 496, 606) within the active region, wherein the connecting plug (307, 427, 517, 627) is positioned within the trench (285, 406, 496, 606), and the connecting plug (307, 427, 517, 627) comprises titanium nitride (TiN) and tungsten (W), or
comprising a thin slot (345) within the STI region (334), wherein the connecting plug (3595, 3795) is positioned within the thin slot (345), and the connecting plug (3595, 3795) comprises a highly doped semiconductor material or TiN, wherein the epitaxial semiconductor material of the first conductive region (3591) is further over the top surface of the connecting plug (3795), and the second sidewall of the connecting plug (3795) is opposite to the first sidewall of the connecting plug (3795).

5. The semiconductor device structure of anyone of the claims 1 to 4, wherein the transistor is a fin field-effect transistor (FinFET), a GAA transistor or a CFET, and the STI region has a top surface lower than the original semiconductor surface.

6. The semiconductor device structure of claim 5, wherein the first conductive region (3291, 3591, 4691, 5791, 6691, 3281, 3581, 4681, 5781, 6681) comprises a selectively epitaxial grown material.

7. The semiconductor device structure of claim 6, wherein
the connecting plug (307, 427, 517, 627) is within the active region, and the first conductive region (3281, 3291, 4681, 4691, 5781, 5791, 6681, 6691) only extends from a vertical sidewall of the active region right under a spacer structure (281, 441, 551, 641) covering the gate structure, or
the connecting plug (3595, 3795) is within the STI region (334), and the first conductive region (3581, 3591) extends from a vertical sidewall of the active region right under a spacer structure covering the gate structure and from a horizontal surface of the active region close to the top surface of the STI region (334).

8. The semiconductor device structure of anyone of the claims 1 to 7, further comprising a metal cap (M0) (475, 585, 675) covering the first conductive region (4681, 4691, 5781, 5791, 6681, 6691).

9. A semiconductor device structure, comprising:
a semiconductor substrate with an original semiconductor surface and an active region;
a shallow trench isolation (STI) region (394, 484, 594) surrounding the active region;
a transistor formed based on the active region and comprising a gate structure, a first conductive region (4681, 5781, 6681, 4691, 5791, 6691), a second conductive region (4682, 5782, 6682, 4692, 5792, 6692), and a channel region between the first conductive region (4681, 5781, 6681, 4691, 5791, 6691) and the second conductive region (4682, 5782, 6682, 4692, 5792, 6692);
an interconnection structure (392, 482, 592) extending beyond the transistor, wherein the interconnection structure (392, 482, 592) is disposed under the original semiconductor surface and within the STI region (394, 484, 594);
a connecting plug (427, 517, 627) electrically connecting the interconnection structure (392, 482, 592) to the first conductive region (4681, 5781, 6681, 4691, 5791, 6691) of the transistor; and
a metal cap (M0) (475, 585, 675) covering an epitaxial semiconductor material of the first conductive region (4681, 5781, 6681, 4691, 5791, 6691) and the connecting plug (427, 517, 627).

10. The semiconductor device structure of claim 9, wherein the interconnection structure (392, 482, 592) is isolated from the semiconductor substrate by an insulating region (393, 483, 593), the insulating region (393, 483, 593) comprises a first spacer (3931, 4831, 5931) on a first side of the interconnection structure (282, 332, 392, 482, 592) and a second spacer (3932, 4832, 5932) on a second side of the interconnection structure (392, 482, 592), and the material of the first spacer is different from that of the second spacer.

11. The semiconductor device structure of claim 9 or 10, wherein a sidewall of the connecting plug (427, 517, 627) is aligned with and contacts to a sidewall of the interconnection structure (392, 482, 592).

12. The semiconductor device structure of claim 11, further comprising a trench (406, 496, 606) within the active region, wherein the connecting plug (427, 517, 627) is positioned within the trench (406, 496, 606), and the connecting plug (427, 517, 627) comprises tungsten.

13. The semiconductor device structure of anyone of the claims 9 to 12, wherein the transistor is a FinFET, the channel region comprises a fin structure, and the STI region has a top surface lower than the original semiconductor surface.

14. The semiconductor device structure of claim 13, wherein the first conductive region (4681, 5781, 6681, 4691, 5791, 6691) comprises an epitaxial semiconductor material; wherein the connecting plug (427, 517, 627) is within the active region, and the first conductive region (4681, 5781, 6681, 4691, 5791, 6691) extends from a vertical sidewall of the fin structure right under a spacer structure (441, 551, 641) covering the gate structure and from a horizontal surface of the active region close to the top surface of the STI region (394,484,594).

15. The semiconductor device structure of anyone of the claims 9 to 12, wherein the transistor is a gate-all-around (GAA) transistor, the channel region comprises a plurality of nanosheets (5951), and the STI region (594) has a top surface lower than the top of the plurality of nanosheet structures (5951), preferably
wherein the first conductive region (6681, 6691) comprises an epitaxial semiconductor material; wherein the connecting plug (627) is within the active region, and the first conductive region (6681, 6691) extends from both vertical sidewalls of the plurality of nanosheets (5951) right under a spacer structure (641) covering the gate structure and a horizontal surface of the active region close to the top surface of STI region (594).
